# EUROPÄISCHE PATENTSCHRIFT

(11) **EP 3 712 292 B1**
(45) Veröffentlichungstag und Bekanntmachung des Hinweises auf die Patenterteilung: **02.08.2023**
(21) Anmeldenummer: 19163771.9
(22) Anmeldetag: 19.03.2019
(51) Int. Cl.: B32B 15/01, C22C 38/00, C22C 38/04, C23C 14/16, C23C 14/58, C23C 2/02, C23C 28/02

(54) **BAUTEIL UMFASSEND EIN STAHLSUBSTRAT, EINE ZWISCHENSCHICHT UND EINE KORROSIONSSCHUTZBESCHICHTUNG, ENTSPRECHENDE VERFAHREN UND VERWENDUNGEN**
COMPONENT CONSISTING OF A STEEL SUBSTRATE, AN INTERMEDIATE COATING LAYER AND A CORROSION PROTECTION LAYER, AS WELL AS THEIR PROCESS OF MANUFACTURE
COMPOSANT COMPRENANT UN SUBSTRAT EN ACIER, UNE COUCHE DE REVÊTEMENT INTERMÉDIAIRE ET UNE COUCHE PROTECTION CONTRE LA CORROSION, LEUR PROCÉDÉ DE FABRICATION

(43) Veröffentlichungstag der Anmeldung: 23.09.2020
(73) Patentinhaber: ThyssenKrupp Steel Europe AG, 47166 Duisburg (DE)
(72) Erfinder: Stille, Sebastian, 44263 Dortmund (DE); Bienholz, Stefan, 44795 Bochum (DE)
(74) Vertreter: Eisenführ Speiser

(56) Entgegenhaltungen:
- DE-A1-102014 004 656

## Beschreibung

Die vorliegende Erfindung betrifft ein Bauteil umfassend ein Stahlsubstrat, eine das Stahlsubstrat bedeckende metallische Zwischenschicht und eine die Zwischenschicht bedeckende Korrosionsschutzbeschichtung. Weitere Details des erfindungsgemäßen Bauteils ergeben sich aus den beigefügten Patentansprüchen sowie der nachfolgenden Beschreibung. Die vorliegende Erfindung betrifft zudem ein entsprechendes Verfahren zum Herstellen eines Bauteils. Jeweils ergeben sich Einzelheiten aus den beigefügten Patentansprüchen und der nachfolgenden Beschreibung.

Ein erfindungsgemäßes Bauteil liegt häufig in Form eines Stahlbleches und dabei vorzugsweise in Form eines PHS-Stahlbleches (presshärtendes Stahlblech) vor.

Ein gehärtetes Bauteil ist vorzugsweise ein Stahlformteil, welches aus einem entsprechenden presshärtenden Stahlblech hergestellt ist.

Zur Bezeichnung "presshärtendes Stahlblech" (bzw. "PHS-Stahlblech") sei auf das Dokument DE 10 2012 024 616 A1 verwiesen. Wie dort ausgeführt, lassen sich aus presshärtenden Stahlblechen gehärtete Bauteile mit extrem hoher Festigkeit fertigen, indem das Stahlblech über die Austenitisierungstemperatur erhitzt und durch Abkühlung während des Pressens ein im Wesentlichen rein martensitisches Gefüge erhalten wird.

Die vorliegende Erfindung ist jedoch nicht auf den Einsatz von presshärtendem Stahlblech (als Bauteil) bzw. auf daraus hergestellte Stahlformteile (als gehärtetes Bauteil) beschränkt.

Im Rahmen der vorliegenden Erfindung ist das Stahlsubstrat des Bauteils und des entsprechenden gehärteten Bauteils vorzugsweise ein Mangan-Bor-Stahl. Bei der Warmumformung solcher Mangan-Bor-Stähle kommen üblicherweise Korrosionsschutzbeschichtungen zum Einsatz, beispielsweise Al-Si-Beschichtungen, um ein Verzundern der Oberfläche zu verhindern. Solche Al-Si-Beschichtungen schützen durch ihre Barrierewirkung jedoch nur passiv vor Korrosion. Der Einsatz von aktiv schützenden Zn-Überzügen ist aufgrund des vergleichsweise niedrigen Schmelzpunkts des reinen Zinks von 419 °C nur eingeschränkt möglich. Es wird nämlich beobachtet, dass bei Umformung flüssiges Zink in den Grundwerkstoff (das Stahlsubstrat) eindringt und dort zu einer Rissbildung führt (sogenannte Flüssigmetallversprödung). Vereinzelt wird dieses Problem bereits umgangen, indem der Zn-Überzug durch eine höherschmelzende Legierung substituiert wird, sodass dies bei der Warmumformung nur zu einem ausreichend geringen Anteil in flüssiger Form vorliegt. Insoweit sei erneut auf das Dokument DE 10 2012 024 616 A1 verwiesen. Dort wird ein Stahlblech offenbart, insbesondere ein presshärtendes Stahlblech, mit einer Stahl-Substratschicht und einer Zink und Mangan enthaltenden Korrosionsschutzschicht. Die Korrosionsschutzschicht ist dabei galvanisch auf die Substratschicht aufgetragen und weist einen Mangananteil von wenigstens 5 Gew.-%, aber maximal 25 Gew.-% auf. Gemäß der Offenbarung sollte ein Mangananteil von 25 Gew.-% nicht überschritten werden.

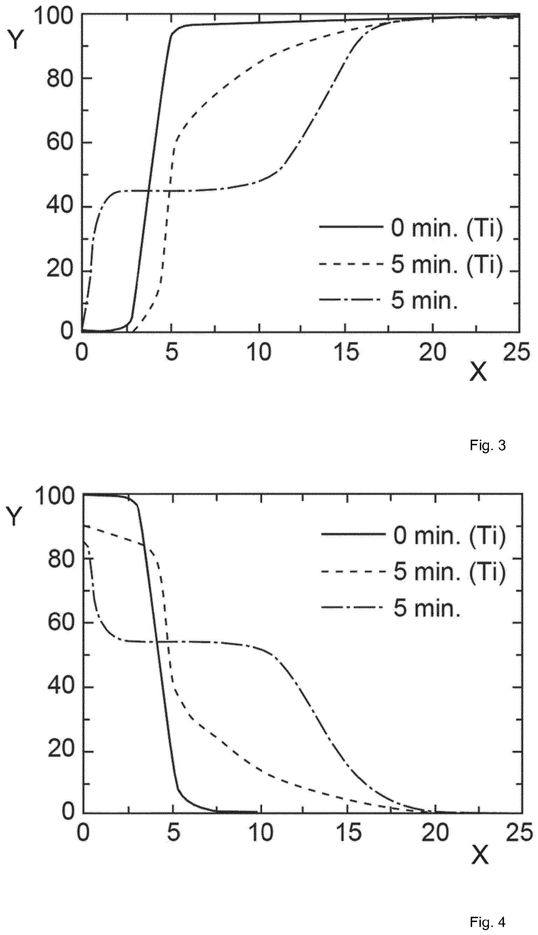

Generell gilt jedoch, dass die opfernde Wirkung einer Korrosionsschutzbeschichtung bei einer Zn-Legierung in der Regel geringer ist als bei reinem Zink. Bei der Glühung des beschichteten Stahlsubstrats, wie sie bei der Warmumformung typischerweise bei etwa 900 °C erfolgt, kommt es zudem typischerweise zu einer starken Eindiffusion von Eisen in die Beschichtungszusammensetzung (bereits an dieser Stelle sei auf die eigenen Untersuchungen gemäß Fig. 3 verwiesen). Durch diese Eindiffusion wird die kathodische Schutzwirkung der Beschichtung typischerweise weiter herabgesetzt.

Eine solche Eisendiffusion ist generell unerwünscht.

WO 2014/124749 offenbart ein beschichtetes Stahlsubstrat, auf dem eine metallische Flash-Schicht angeordnet ist, wobei diese metallische Flash-Schicht eine erste Flash-Schicht umfasst, die dem Stahlsubstrat benachbart ist und ein oder mehr Elemente ausgewählt aus Al, Ag, Au, Cr, Cu, Mo, Ni, Sn und Zr enthält, und eine zweite Flash-Schicht, die Fe als Hauptbestandteil enthält.

DE 10 2014 004 656 A1 offenbart ein Bauteil mit einem aus einem warmumformbaren Stahl gebildeten Grundkörper, welcher zumindest in einem Teilbereich mit einer Beschichtung versehen ist, die eine erste Schicht und wenigstens eine zumindest Zink aufweisende und in Überdeckung mit der ersten Schicht angeordnete zweite Schicht aufweist. Die erste Schicht ist dabei zwischen dem Grundkörper und der zweiten Schicht angeordnet und als Flüssigmetallversprödungs- und Diffusionssperrschicht ausgebildet. Die erste Schicht weist dabei vorzugsweise eine Oxid-, Nitrid-, Sulfid-, Carbid-, Hydrat-, Silikat-, Chromat-, Molybdat-, Wolfram-, Vanadat-, Titanat-, Borat-, Carbonat-, Chlorid- oder Phosphat-Verbindung eines unedlen Metalls auf.

EP 2 049 699 B1 betrifft ein Verfahren zum Beschichten von Stahlbändern und ein beschichtetes Stahlband. Das Stahlband besitzt einen Mangan-Anteil im Bereich von 6 - 30 %. Auf das Stahlband wird vor dem letzten Glühen eine Aluminiumschicht aufgetragen, auf die nach dem letzten Glühen ein Überzug aus einem schmelzflüssigen Metall aufgebracht wird. Die Aluminiumschicht wird vorzugsweise durch PVD-Beschichten aufgetragen. Die Schichtdicke der Zwischenschicht ist vorzugsweise auf 50 nm bis 1000 nm beschränkt. EP 2 049 699 B1 offenbart, dass es bei einer der anschließenden Schmelzbeschichtungen vorgeschalteten notwendigen Glühbehandlung zu einer Diffusion des Eisens des Stahlbands in das aufgetragene Aluminium kommt, sodass im Zuge der Glühung auf dem Stahlband eine metallische, im Wesentlichen aus Al und Fe bestehende Auflage entsteht, die stoffschlüssig mit dem durch das Stahlband gebildeten Untergrund verbunden ist.

EP 2 435 603 B1 offenbart ein Verfahren zum Herstellen eines Stahlflachprodukts, das aus einer aus einem Stahlwerkstoff bestehenden Grundschicht und einem darauf aufgetragenen, vor Korrosion schützenden mehrschichtigen Überzug gebildet ist. Auf einer Grundschicht wird auf spezifische Weise eine Zinkschicht aufgebracht, auf der Oberfläche der Zinkschicht wird eine spezifische Aluminiumschicht aufgebracht, auf der Aluminiumschicht wird eine Magnesiumschicht aufgebracht, und es erfolgt dann eine Wärmenachbehandlung, bei der sich in Richtung der Oberfläche des Überzugs oberhalb der Al-Schicht eine MgZn₂-Schicht in dem Überzug bildet.

EP 2 848 709 A1 offenbart ein Verfahren zum Herstellen eines mit einem metallischen, vor Korrosion schützenden Überzug versehenen Stahlbauteils und ein Stahlbauteil.

WO 2016/071399 A1 offenbart ein Verfahren zum Herstellen einer Korrosionsschutzbeschichtung für härtbare Stahlbleche und eine Korrosionsschutzschicht für härtbare Stahlbleche.

WO 2015/090621 A1 offenbart ein Stahlsubstrat, welches mit einer Zink-basierten Korrosionsschutzbeschichtung versehen ist. Zwischen dem Substrat und der Zink-basierten Beschichtungsschicht kann eine Diffusionsbarriereschicht angeordnet sein, wobei es sich vorzugsweise um eine Wolframschicht oder eine Wolfram-Legierungsschicht handeln kann. Es wird offenbart, dass eine vergleichsweise dünne Barriereschicht ausreicht, mit einer Dicke im Bereich von 2 - 50 nm.

Aus dem Stand der Technik sind somit bereits Korrosionsschutzbeschichtungen und teilweise auch Zwischenschichten bzw. Diffusionsbarriereschichten für Stahlbleche (Bauteile) und warmumgeformte Stahlbleche (gehärtete Bauteile) bekannt. Die bereits bekannten Korrosionsschutzbeschichtungen, Zwischenschichten, Bauteile bzw. gehärteten Bauteile sowie die Verfahren zu ihrer jeweiligen Herstellung erscheinen jedoch noch nicht optimal.

Insbesondere besteht ein erheblicher Bedarf an Bauteilen, die ein Stahlsubstrat und eine Korrosionsschutzbeschichtung besitzen, wobei eine Eisendiffusion aus dem Stahlsubstrat in die Korrosionsschutzbeschichtung zumindest weitgehend unterbunden ist.

Zudem besteht ein erheblicher Bedarf an Bauteilen, bei denen die Diffusion von Elementen der Korrosionsschutzbeschichtung in das Stahlsubstrat hinein besonders niedrig ist.

Insbesondere besteht ein Bedarf an verzinkten Bauteilen, die effektiv gegen eine schädliche Zn-Infiltration bei Warmumformung, die sogenannte Flüssigmetallversprödung, geschützt sind, welche in der Regel ursächlich für eine ausgeprägte Rissbildung im Grundwerkstoff ist.

Zudem besteht ein Bedarf an entsprechenden Bauteilen, bei denen - anders als beispielsweise gemäß WO 2015/090621 A1 - keine Schichten aus besonders sprödem Material (wie z. B. Wolfram) auf dem Stahlsubstrat angeordnet werden. Spröde Schichten neigen nämlich dazu, bei einer späteren Warmumformung zu reißen; die resultierenden gehärteten Stahlbleche (gehärtete Bauteile) besitzen dann inakzeptable Risse.

Die vorliegende Erfindung betrifft mit ihren diversen Aspekten, die miteinander über eine gemeinsame technische Lehre verknüpft sind, einzelne oder sämtliche der vorstehend genannten Aufgabenstellungen bzw. Bedürfnisse.

Gemäß einem primären Aspekt der vorliegenden Erfindung, welcher ein Bauteil (vorzugsweise ein beschichtetes Stahlblech) betrifft, werden zahlreiche der vorstehend angegebenen Aufgaben-Problemstellungen gelöst durch ein Bauteil umfassend
- ein Stahlsubstrat, dessen Gefüge in ein martensitisches Gefüge umwandelbar ist,
- eine das Stahlsubstrat bedeckende metallische Zwischenschicht, deren Hauptbestandteil Titan ist
   und
- eine die Zwischenschicht bedeckende Korrosionsschutzbeschichtung,

wobei die Korrosionsschutzbeschichtung eine oder mehr Schichten umfasst und die eine bzw. zumindest die an der metallischen Zwischenschicht anliegende Schicht der Korrosionsschutzbeschichtung metallisch ist und sich stofflich von der Zwischenschicht unterscheidet
   und
wobei der Anteil an Titan in der das Stahlsubstrat bedeckenden metallischen Zwischenschicht größer oder gleich 90 Gew.-% ist, bezogen auf die Gesamtmasse der Zwischenschicht,
   und
wobei die metallische Zwischenschicht, deren Hauptbestandteil Titan ist, eine Dicke von mindestens 100 nm besitzt.

Das erfindungsgemäße Bauteil ist regelmäßig dazu geeignet und vorgesehen, zu einem gehärteten Bauteil weiterverarbeitet zu werden, wie es weiter unten näher definiert ist.

Unter einer "das Stahlsubstrat bedeckenden metallischen Zwischenschicht" ist im vorliegenden Text eine Zwischenschicht zu verstehen, die im direkten Kontakt zum Stahlsubstrat steht. Mit anderen Worten sind irgendwelche zwischen der metallischen Zwischenschicht und dem Stahlsubstrat angeordneten weiteren zwischenliegenden Schichten nicht vorgesehen.

In der das Stahlsubstrat bedeckenden metallischen Zwischenschicht ist erfindungsgemäß der Hauptbestandteil Titan. Dies bedeutet, dass der Massenanteil an Titan in der metallischen Zwischenschicht höher ist als der Massenanteil irgendeines anderen Metalls in der Zwischenschicht. Der Anteil an Titan in der metallischen Zwischenschicht ist dabei größer oder gleich 90 Gew.-%, bezogen auf die Gesamtmasse der Zwischenschicht. Die Erfindung (in ihren sämtlichen Aspekten) basiert auf der überraschenden Erkenntnis, dass eine metallische Zwischenschicht, welche das Stahlsubstrat bedeckt (kontaktiert) und deren Hauptbestandteil Titan ist, eine hervorragende Diffusionsbarriere ist, welche sowohl den Durchtritt von Eisen in die Korrosionsschutzbeschichtung als auch den Durchtritt von Elementen üblicher Korrosionsschutzbeschichtungen für die Zwecke von in der stahlverarbeitenden Industrie üblichen Verfahrensschritten hervorragend verzögert. Die erfindungsgemäß vorgesehene metallische Zwischenschicht, deren Hauptbestandteil Titan ist, trägt im Übrigen nicht zu einer erhöhten Sprödigkeit des Bauteils bei, wie es beispielsweise Diffusionsbarrieren aus spröden Metallen wie Wolfram tun. Erfindungsgemäße Bauteile sind somit vor den inakzeptablen Ergebnissen einer übermäßigen Diffusion von Eisen in Richtung der Korrosionsschutzbeschichtung und von Elementen der Korrosionsschutzbeschichtung in Richtung des Stahlsubstrats sowie vor einer inakzeptablen Versprödung weitgehend geschützt. Ebenfalls besteht beispielsweise effektiver Schutz gegen eine schädliche Zn-Infiltration, die sogenannte Flüssigmetallversprödung, die für eine ausgeprägte Rissbildung im Grundwerkstoff (Stahlsubstrat) häufig verantwortlich ist, wenn in der Korrosionsschutzbeschichtung Zink enthalten ist.

Bevorzugt ist ein erfindungsgemäßes Bauteil, wobei der Hauptbestandteil der Metallatome der Korrosionsschutzbeschichtung bzw. der Hauptbestandteil der Metallatome der an der metallischen Zwischenschicht anliegenden metallischen Schicht der Korrosionsschutzbeschichtung ausgewählt ist aus der Gruppe bestehend aus Zink und Mangan
und/oder
metallisches Zink und/oder metallisches Mangan in der einen bzw. zumindest der an der metallischen Zwischenschicht anliegenden metallischen Schicht der Korrosionsschutzbeschichtung enthalten sind.

Die Elemente Zink und Mangan sind übliche metallische Elemente, die in Korrosionsschutzbeschichtungen für Stahlbleche vielfach Verwendung finden. Ihr Einsatz ist auch im Rahmen der vorliegenden Erfindung bevorzugt. Abhängig von den Erfordernissen des Einzelfalls ist der Einsatz von Zink oder der Einsatz von Mangan in manchen Fällen bevorzugt. In eigenen Untersuchungen haben sich erfindungsgemäße Bauteile unabhängig davon bewährt, ob der Hauptbestandteil der Metallatome der Korrosionsschutzbeschichtung Zink oder Mangan war. Lediglich aus Gründen der Übersichtlichkeit fokussiert der nachfolgende Text auf den Einsatz von Zink; die Ausführungen betreffend Zink gelten aber entsprechend auch für den Einsatz von Mangan.

In einem erfindungsgemäßen Bauteil (wie vorstehend beschrieben, vorzugsweise wie vorstehend oder nachfolgend als bevorzugt bezeichnet) kann die Korrosionsschutzbeschichtung trotz des Vorhandenseins einer das Stahlsubstrat (weitgehend) bedeckenden metallischen Zwischenschicht an manchen Stellen durchaus in direktem Kontakt mit dem Stahlsubstrat stehen. Bevorzugt ist jedoch ein erfindungsgemäßes Bauteil, wobei zumindest 90 % der dem Stahlsubstrat zugewandten Fläche der Korrosionsschutzbeschichtung durch die metallische Zwischenschicht vom Stahlsubstrat getrennt ist, vorzugsweise zumindest 95 %, bevorzugt die gesamte dem Stahlsubstrat zugewandte Fläche der Korrosionsschutzbeschichtung.

Es versteht sich, dass die unmittelbaren Vorteile der erfindungsgemäßen Anwesenheit der das Stahlsubstrat bedeckenden metallischen, Titan als Hauptbestandteil enthaltenden, Zwischenschicht dort zum Tragen kommen, wo die Korrosionsschutzbeschichtung nicht in unmittelbarem Kontakt mit dem Stahlsubstrat steht. Aus diesem Grunde wird der Fachmann in der Regel dafür Sorge tragen, dass ein hoher Anteil der dem Stahlsubstrat zugewandten Fläche der Korrosionsschutzbeschichtung mittels der Zwischenschicht vom Stahlsubstrat getrennt ist.

Bevorzugt ist ein erfindungsgemäßes Bauteil (wie vorstehend beschrieben, vorzugsweise wie vorstehend als bevorzugt bezeichnet) wobei das Stahlsubstrat ein Mangan-Bor-Stahl und/oder ein Stahl mit ferritisch-perlitischem Gefüge ist, bevorzugt ein Mangan-Bor-Stahl mit ferritisch-perlitischem Gefüge ist, besonders bevorzugt ein Mangan-Bor-Stahl mit ferritisch-perlitischem Gefüge ist, welches durch thermische Härtungsbehandlung in ein martensitisches Gefüge umwandelbar ist, ganz besonders bevorzugt ein Mangan-Bor-Stahl mit ferritisch-perlitischem Gefüge und einem Anteil an Mangan von weniger als 5 Gew.-%, bevorzugt 0,7 bis 2 Gew.-% ist, welches durch thermische Härtungsbehandlung in ein martensitisches Gefüge umwandelbar ist.

Für die Zwecke der vorliegenden Erfindung besonders vorteilhaft ist es hierbei, wenn als Stahlsubstrat eines erfindungsgemäßen Bauteils ein Mangan-Bor-Stahl (mit vorzugsweise ferritisch-perlitischem Gefüge) eingesetzt wird, dessen Zusammensetzung wie folgt definiert ist:
0,07 - 0,4 Gew.-% C, 1,0 - 2,5 Gew.-% Mn, 0,06 - 0,9 Gew.-% Si, bis zu 0,03 Gew.-% P, bis zu 0,01 Gew.-% S, bis zu 0,1 Gew.-% Al, bis zu 0,15 Gew.-% Ti, bis zu 0,6 Gew.-% Nb, bis zu 0,005 Gew.-% B, bis zu 0,5 Gew.-% Cr, bis zu 0,5 Gew.-% Mo, wobei die Summe der Gehalte an Cr und Mo höchstens 0,5 Gew.-% beträgt, Rest Eisen und unvermeidbare Verunreinigungen.

Besonders bevorzugt sind Stahlsubstrate (mit vorzugsweise ferritisch-perlitischem Gefüge), deren Zusammensetzung wie folgt definiert ist:
0,07 - 0,4 Gew.-% C, 1,0 - 2 Gew.-% Mn, 0,06 - 0,4 Gew.-% Si, bis zu 0,03 Gew.-% P, bis zu 0,01 Gew.-% S, bis zu 0,1 Gew.-% Al, bis zu 0,15 Gew.-% Ti, bis zu 0,6 Gew.-% Nb, bis zu 0,005 Gew.-% B, bis zu 0,5 Gew.-% Cr, bis zu 0,5 Gew.-% Mo, wobei die Summe der Gehalte an Cr und Mo höchstens 0,5 Gew.-% beträgt, Rest Eisen und unvermeidbare Verunreinigungen.

Und ganz besonders bevorzugt sind Stahlsubstrate (mit vorzugsweise ferritisch-perlitischem Gefüge), die wie folgt definiert sind:
0,07 - 0,4 Gew.-% C, 1,0 - 1,5 Gew.-% Mn, 0,3 - 0,4 Gew.-% Si, bis zu 0,03 Gew.-% P, bis zu 0,01 Gew.-% S, bis zu 0,05 Gew.-% Al, bis zu 0,15 Gew.-% Ti, bis zu 0,6 Gew.-% Nb, bis zu 0,005 Gew.-% B, bis zu 0,5 Gew.-% Cr, bis zu 0,5 Gew.-% Mo, wobei die Summe der Gehalte an Cr und Mo höchstens 0,5 Gew.-% beträgt, Rest Eisen und unvermeidbare Verunreinigungen.

Der für das Stahlsubstrat verwendete Stahlwerkstoff kann dabei sowohl in Reinform wie auch in Kombination in Form von Schichten (3 - 5 Schichten, Bleche übereinander, die vorab durch einen Walzprozess zu einem Stahlband verbunden werden) oder gefügten Stahlblechen (z. B. Kombination von zwei Stahlbändern aneinander, die z. B. durch eine Laserschweißnaht zu einem Stahlband gefügt werden) oder in Form von Platinen / Tailored Blanks Anwendung finden.

Die Dicke des Stahlsubstrats liegt vorzugsweise im Bereich von 0,6 mm bis 7 mm, bevorzugt im Bereich von 0,8 bis 4 mm und besonders bevorzugt im Bereich von 0,8 bis 3 mm. Andere Dicken können jedoch abhängig von den Bedürfnissen des Einzelfalls gewählt werden.

Ein höherer Anteil an Mangan als 5 Gew.-% im Stahlsubstrat ist für die Zwecke der vorliegenden Erfindung nicht bevorzugt, vergleiche die vorstehenden Ausführungen zu bevorzugten Ausgestaltungen.

Bevorzugt ist der Einsatz von Stahlsubstraten, die für die Warmumformung geeignet und vorgesehen sind. Bevorzugt sind deshalb Stahlsubstrate mit Streckgrenzen im Bereich von 250 - 580 MPa und/oder Zugfestigkeiten im Bereich von 400 - 720 MPa.

Die Erfindung betrifft ein erfindungsgemäßes Bauteil, wobei der Anteil an Titan in der das Stahlsubstrat bedeckenden metallischen Zwischenschicht größer oder gleich 90 Gew.-% ist, bezogen auf die Gesamtmasse der Zwischenschicht.

Überraschenderweise lässt sich mit metallischen Zwischenschichten, deren Hauptbestandteil Titan ist, wobei der Anteil an Titan größer oder gleich 90 Gew.-% ist, eine besonders effektive Diffusionsbarrierewirkung erzielen, vergleiche dazu die Beispiele weiter unten im Text.

Bevorzugt ist ein erfindungsgemäßes Bauteil (vorzugsweise wie vorstehend als bevorzugt bezeichnet), wobei das Material der das Stahlsubstrat bedeckenden metallischen Zwischenschicht, deren Hauptbestandteil Titan ist,
- einen Schmelzpunkt besitzt, der größer ist als 1000 °C, vorzugsweise größer als 1200 °C, bevorzugt größer als 1400 °C, besonders bevorzugt größer als 1600 °C
   und/oder
- einen Siedepunkt besitzt, der kleiner ist als 4700 °C, vorzugsweise kleiner ist als 3500 °C.

Insbesondere zur Aufbringung von metallischen Zwischenschichten auf ein Stahlsubstrat mittels PVD-Verfahren sollte das Material der Zwischenschicht einen der vorstehend angegebenen Siedepunkte besitzen, der kleiner ist als 3500 °C.

Bevorzugt ist ein erfindungsgemäßes Bauteil (vorzugsweise wie vorstehend als bevorzugt bezeichnet), wobei
(i) metallisches Zink in der einen bzw. zumindest der an der metallischen Zwischenschicht anliegenden metallischen Schicht der Korrosionsschutzbeschichtung enthalten ist und
   - der Anteil an metallischem Zink in der die Zwischenschicht bedeckenden Korrosionsschutzbeschichtung größer oder gleich 55 Gew.-% ist, vorzugsweise größer oder gleich 96 Gew.-% ist, bezogen auf die Gesamtmasse der Korrosionsschutzbeschichtung
      und/oder
   - der Schmelzpunkt der Korrosionsschutzbeschichtung oder der Schmelzpunkt der einen bzw. zumindest der an der metallischen Zwischenschicht anliegenden metallischen Schicht der Korrosionsschutzbeschichtung größer als oder gleich 419 °C ist, vorzugsweise entweder im Bereich von 419 °C bis 580 °C oder im Bereich größer 600 °C liegt
   oder sogar (und dies ist insbesondere durch die Anwesenheit von Mangan in der Korrosionsschutzbeschichtung erreichbar)
(ii) der Schmelzpunkt der Korrosionsschutzbeschichtung oder der Schmelzpunkt der einen bzw. zumindest der an der metallischen Zwischenschicht anliegenden metallischen Schicht der Korrosionsschutzbeschichtung größer als oder gleich 880 °C ist.

Überraschenderweise sind mit dem erfindungsgemäßen Einsatz einer metallischen Zwischenschicht, deren Hauptbestandteil Titan ist, vorteilhafte technische Effekte verknüpft, die weitgehend unabhängig vom Schmelzpunkt der Korrosionsschutzbeschichtung bzw. vom Schmelzpunkt der einen bzw. zumindest der an der metallischen Zwischenschicht anliegenden metallischen Schicht der Korrosionsschutzbeschichtung sind. Da erfindungsgemäße Bauteile regelmäßig für die Zwecke einer Warmumformung bei einer Temperatur von größer oder gleich 880 °C vorgesehen sind, sind metallische Schichten mit einem geringen Zn-Anteil (und somit vorzugsweise mit einem hohen Mn-Anteil) wirtschaftlich in vielen Fällen interessanter als solche mit einem hohen Zn-Anteil. Der technische Effekt der vorliegenden Erfindung wird jedoch in jedem Falle erreicht.

Bevorzugt ist in vielen Fällen auch ein Bauteil (vorzugsweise wie vorstehend als bevorzugt bezeichnet), wobei die Korrosionsschutzbeschichtung einen Anteil an Mangan umfasst, der
- bezogen auf die Gesamtmasse der Korrosionsschutzbeschichtung im Bereich von 15 bis 40 Gew.-% liegt
   und/oder
- bezogen auf die Gesamtmasse an Mangan und Zink in der Korrosionsschutzbeschichtung
   größer oder gleich 27 % ist, bevorzugt größer oder gleich 30 % ist,
      und/oder
   kleiner 40 % ist, bevorzugt kleiner 35 % ist,
      und/oder
   im Bereich von größer als 25 % bis 40 % liegt, bevorzugt im Bereich von größer als 25 % bis 35 %, besonders bevorzugt im Bereich von 27 % bis 35 %.

Solche Korrosionsschutzbeschichtungen haben regelmäßig einen hohen Schmelzpunkt und sind für Warmumformverfahren deshalb besonders geeignet.

Bevorzugt ist ein erfindungsgemäßes Bauteil (vorzugsweise wie vorstehend als bevorzugt bezeichnet), wobei
die metallische Zwischenschicht, deren Hauptbestandteil Titan ist, eine Dicke von höchstens 500 nm besitzt, bevorzugt eine Dicke von höchstens 400 nm, besonders bevorzugt eine Dicke von höchstens 300 nm
   und/oder
die metallische Zwischenschicht, deren Hauptbestandteil Titan ist, eine Dicke von mindestens 150 nm besitzt.

Die metallische Zwischenschicht (mit dem Hauptbestandteil Titan) eines erfindungsgemä-βen Bauteils fungiert bereits effektiv als Diffusionsbarriere, wenn sie eine sehr geringe Schichtdicke besitzt. Bereits wenige Atomlagen, das heißt eine Dicke von beispielsweise nur 1 nm, tragen effektiv zur Diffusionsbarrierewirkung bei. Bei Dicken von mehr als 500 nm hat sich in eigenen Untersuchungen regelmäßig kein relevanter technischer Unterschied mehr gezeigt, sodass metallische Zwischenschichten mit einer Dicke von größer 500 nm nur in Ausnahmefällen vorteilhaft sind.

Bevorzugt ist ein erfindungsgemäßes Bauteil (vorzugsweise wie vorstehend als bevorzugt bezeichnet), wobei die Korrosionsschutzbeschichtung eine Dicke von zumindest 1 µm besitzt, bevorzugt eine Dicke im Bereich von 3 µm bis 50 µm besitzt, besonders bevorzugt eine Dicke im Bereich von 5 µm bis 30 µm besitzt, ganz besonders bevorzugt im Bereich von 7 µm bis 20 µm besitzt.

Derartige Dicken werden vom Fachmann in üblicher Weise eingestellt.

Bevorzugt ist ein erfindungsgemäßes Bauteil (vorzugsweise wie vorstehend als bevorzugt bezeichnet), wobei
- die das Stahlsubstrat bedeckende metallische Zwischenschicht, deren Hauptbestandteil Titan ist,
   und/oder
- die die Zwischenschicht bedeckende Korrosionsschutzbeschichtung mittels physikalischer Gasphasenabscheidung appliziert ist bzw. sind.

Ein Vorteil der vorliegenden Erfindung ist es, dass sowohl die metallische Zwischenschicht als auch die die Zwischenschicht bedeckende Korrosionsschutzbeschichtung mittels physikalischer Gasphasenabscheidung (PVD) applizierbar sind. Der Einsatz von PVD-Verfahren ist im Rahmen der vorliegenden Erfindung bevorzugt.

Offenbart wird auch ein gehärtetes Bauteil umfassend
- ein Stahlsubstrat
- eine das Stahlsubstrat schützende Korrosionsschutzbeschichtung, wobei die Korrosionsschutzbeschichtung Titan, vorzugsweise metallisches Titan umfasst.

Ein gehärtetes Bauteil ist vorzugsweise aus einem erfindungsgemäßen Bauteil (vorzugsweise wie vorstehend als bevorzugt bezeichnet) hergestellt.

Bei der Umwandlung eines erfindungsgemäßen Bauteils in ein gehärtetes Bauteil (vgl. hierzu auch die Ausführungen zu Verfahren weiter unten) tritt Titan aus dem Material der metallischen Zwischenschicht in einem gewissen Umfang in das Material der Korrosionsschutzbeschichtung ein. Es resultiert eine das Stahlsubstrat schützende Korrosionsschutzbeschichtung, welche auch Titan, vorzugsweise metallisches Titan, umfasst. Hierin liegt ein signifikanter Unterschied im Vergleich mit Korrosionsschutzbeschichtungen, die aus dem Stand der Technik bekannt sind. Überraschenderweise ist im Übrigen trotz des Eintritts von Titan in das Material der Korrosionsschutzbeschichtung während üblicher Warmumformprozesse ausgehend von einem noch nicht gehärteten Bauteil hin zu einem gehärteten Bauteil die Diffusionsbarrierewirkung der metallischen Zwischenschicht (die insbesondere der Diffusion von Eisen in die Korrosionsschutzbeschichtung und der Diffusion von Zink und/oder Mangan in das Stahlsubstrat entgegensteht) hervorragend.

Bevorzugt ist ein gehärtetes Bauteil, welches erhältlich ist durch Härten eines erfindungsgemäßen Bauteils (vorzugsweise wie vorstehend als bevorzugt bezeichnet)
und/oder
ein warmumgeformtes gehärtetes Bauteil ist.

Besonders bevorzugt ist somit ein gehärtetes Bauteil, welches durch Härten eines erfindungsgemäßen Bauteils mittels Warmumformung erhalten ist.

Bevorzugt ist ein gehärtetes Bauteil (vorzugsweise wie vorstehend als bevorzugt bezeichnet), wobei das Stahlsubstrat überwiegend ein martensitisches Gefüge besitzt. Hierbei versteht es sich, dass insbesondere dort, wo im Stahlsubstrat aufgrund von konvektiven oder Diffusionsprozessen nennenswerte Anteile an Zink, Mangan oder Titan vorliegen, auch andere Gefüge/Phasen vorliegen können.

Das martensitische Gefüge, welches in bevorzugten gehärteten Bauteilen im Stahlsubstrat vorliegt, lässt sich in üblicher Weise durch dem Fachmann bekannte Warmumformprozesse ausgehend von ferritisch-perlitischem Stahlsubstrat erzeugen.

Bevorzugt ist ein gehärtetes Bauteil (vorzugsweise wie vorstehend als bevorzugt bezeichnet), wobei das Stahlsubstrat in einer der Korrosionsschutzbeschichtung zugewandten Zone mit Titan legiert ist, vorzugsweise mit Titan und zumindest einem Metall ausgewählt aus der Gruppe bestehend aus Zink und Mangan legiert ist.

Ein solches gehärtetes Bauteil resultiert insbesondere dann, wenn ausgehend von einem erfindungsgemäßen Bauteil bei der Warmumformung Titan aus der metallischen Zwischenschicht in gewissem (geringen) Umfang in das Stahlsubstrat eindiffundiert bzw. gemeinsam mit dem Titan auch Zink und/oder Mangan in das Stahlsubstrat eindiffundieren (Zink und Mangan sind nach den vorstehenden Ausführungen bevorzugte Metalle für die Korrosionsschutzbeschichtung). Üblicherweise ändert die Anwesenheit von Titan, Zink und/oder Mangan nichts an dem Umstand, dass in einem (bevorzugten) gehärteten Bauteil das Gefüge des Stahlsubstrats martensitisch ist. Wie vorstehend ausgeführt ist ein martensitisches Gefüge bevorzugt; ein martensitisches Gefüge im Stahlsubstrat, wobei das Stahlsubstrat in der der Korrosionsschutzbeschichtung zugewandten Zone mit Titan, Zink und/oder Mangan legiert ist, ist daher besonders bevorzugt.

Bevorzugt ist ein gehärtetes Bauteil (vorzugsweise wie vorstehend als bevorzugt bezeichnet), wobei das Stahlsubstrat und die Korrosionsschutzbeschichtung durch eine Übergangszone verbunden sind,
- in der Eisen, Titan, und der metallische Hauptbestandteil der Korrosionsschutzbeschichtung vorliegen, wobei ausgehend von einem dem Stahlsubstrat nahen Bereich der Übergangszone in Richtung der Korrosionsschutzbeschichtung ein Wechsel des metallischen Hauptbestandteils erfolgt, von Eisen zum metallischen Hauptbestandteil der Korrosionsschutzbeschichtung, wobei der Hauptbestandteil der Korrosionsschutzbeschichtung vorzugsweise ausgewählt ist aus der Gruppe bestehend aus Zink und Mangan
   und/oder
- in der sich der Massenanteil an Eisen, ausgehend von einem dem Stahlsubstrat nahen Bereich der Übergangszone in Richtung der Korrosionsschutzbeschichtung, auf einer Strecke von höchstens 10 µm, vorzugsweise 5 µm, von einem ersten Massenanteil auf die Hälfte oder weniger als die Hälfte des ersten Anteils verringert, wobei der erste Massenanteil an Eisen in dem dem Stahlsubstrat nahen Bereich der Übergangszone bevorzugt zumindest 80 Gew.-% beträgt.

Überraschenderweise lassen sich durch Verfahren (wie nachfolgend definiert) gehärtete Bauteile erzeugen, welche eine Übergangszone mit einer oder beiden der vorstehend definierten Eigenschaften besitzen. In der besagten Übergangszone wechselt daher in den bevorzugten gehärteten Bauteilen der metallische Hauptbestandteil und/oder verringert sich der Massenanteil an Eisen auf einer nur sehr kurzen Strecke von höchstens 10 µm. Diese Eigenschaften der (sehr schmalen) Übergangszone sind dabei auf die hervorragende Diffusionsbarrierewirkung der metallischen Zwischenschicht auf Basis von Titan zurückzuführen, die im (noch nicht gehärteten) erfindungsgemäßen Bauteil vorliegt.

Bevorzugt ist ein gehärtetes Bauteil (vorzugsweise wie vorstehend als bevorzugt bezeichnet), wobei in der Korrosionsschutzbeschichtung in einer Tiefe von 2 µm, vorzugsweise im Bereich von 1 bis 3 µm, gemessen von der Außenfläche der Korrosionsschutzbeschichtung, der Anteil an Eisen niedriger ist als 25 Gew.-%, vorzugsweise niedriger ist als 20 Gew.-%, bestimmt mittels GDOES. Bevorzugt sind somit gehärtete Bauteile, bei denen während der Herstellung und während etwaiger Nachbehandlungen Eisen nicht in entscheidendem Umfang in die Korrosionsschutzbeschichtung eintritt. Die Bestimmung des Anteils an Eisen mittels GDOES erfolgt gemäß der ISO-Norm 11505:2012 ("Surface chemical analysis - General procedure for quantitative compositional depth profiling by glow discharge optical emission spectrometry"). Bei diesem Messverfahren wird durch Anlegen von Hochspannung an eine mit Argongas gespülte Glimmentladungslampe ein Plasma erzeugt. Mit Hilfe des Plasmas werden einerseits Ionen für einen Sputterprozess erzeugt (um die zu untersuchende Oberfläche abzutragen) und andererseits werden die abgetragenen Atome zur Emissionsstrahlung angeregt. Das emittierte Licht wird in einem Polychromator spektral zerlegt und die Lichtintensität wird durch Photomultiplier in elektrische Signale umgewandelt. Anschließend werden diese Signale in einer PC-gestützten Steuer- und Auswerteeinheit digitalisiert und ausgewertet.

Bevorzugt ist ein gehärtetes Bauteil (vorzugsweise wie vorstehend als bevorzugt bezeichnet), wobei für Titan im Massenanteil -Tiefe-Diagramm (Quantitatives Tiefenprofil) ein Maximum des Massenanteils in einer Tiefe > 0 µm vorliegt, vorzugsweise in einer Tiefe im Bereich von 2 bis 20 µm, gemessen von der Außenfläche der Korrosionsschutzbeschichtung.

Wenngleich somit üblicherweise bei Herstellung eines gehärteten Bauteils aus einem (noch ungehärteten) Bauteil, beispielsweise mittels Warmumformung, Titan in gewissem Umfang in die Korrosionsschutzbeschichtung eindiffundiert, wird vorteilhafterweise kein Zustand angestrebt oder erreicht, in dem die Titankonzentration an der Außenfläche der Korrosionsschutzbeschichtung so hoch ist wie innerhalb des gehärteten Bauteils.

Die vorliegende Erfindung betrifft auch ein Verfahren zum Herstellen eines erfindungsgemäßen Bauteils (vorzugsweise wie vorstehend als bevorzugt bezeichnet). Ein erfindungsgemäßes Verfahren umfasst die folgenden Schritte:
- Herstellen oder Bereitstellen eines Stahlsubstrats, wobei das Gefüge des Stahlsubstrats in ein martensitisches Gefüge umwandelbar ist,
- Applizieren von (i) Titan oder (ii) Titan und einem oder mehreren weiteren Metallen auf das Stahlsubstrat, so dass eine das Stahlsubstrat bedeckende metallische Zwischenschicht resultiert, deren Hauptbestandteil Titan ist,
- Applizieren von einem oder mehreren Metallen auf die metallische Zwischenschicht, so dass eine die Zwischenschicht bedeckende Korrosionsschutzbeschichtung resultiert.

Hinsichtlich bevorzugter Stahlsubstrate und bevorzugter Metalle zur Ausbildung der die Zwischenschicht bedeckenden Korrosionsschutzbeschichtung und hinsichtlich bevorzugter Eigenschaften des resultierenden Bauteils gelten die vorstehenden Ausführungen entsprechend. Umgekehrt gelten sämtliche Ausführungen, die vorstehend oder nachfolgend im Zusammenhang mit dem erfindungsgemäßen Verfahren gemacht werden, entsprechend für die erfindungsgemäßen Bauteile bzw. die ebenfalls offenbarten gehärteten Bauteile.

Insgesamt gilt für sämtliche im Rahmen des vorliegenden Textes erläuterten Aspekte der Erfindung, dass bevorzugte Ausgestaltungen, die zu einem dieser Aspekte dargelegt werden, mit den entsprechenden Änderungen auch für die anderen Aspekte zutreffen.

Das Applizieren von Titan bzw. Titan und einem oder mehreren weiteren Metallen auf das Stahlsubstrat und das Applizieren von einem oder mehreren Metallen auf die metallische Zwischenschicht kann auf unterschiedliche Weise erfolgen. Es ist ein erfindungsgemäßes Verfahren bevorzugt, wobei das Applizieren der ein- oder mehrlagigen metallischen Schicht mittels eines Verfahrens erfolgt, das ausgewählt ist aus der Gruppe bestehend aus elektrolytische Abscheidung, galvanische Abscheidung, physikalische Gasphasenabscheidung, Chemical Vapour Deposition, Tauchverfahren, Slurry-Verfahren, thermisches Spritzen und Kombinationen davon, bevorzugt elektrolytisch oder mittels physikalischer Gasphasenabscheidung erfolgt, und besonders bevorzugt mittels physikalischer Gasphasenabscheidung erfolgt.

Wie vorstehend bereits ausgeführt ist in einem erfindungsgemäßen Bauteil vorzugsweise der Hauptbestandteil einer Korrosionsschutzbeschichtung Zink oder Mangan. Entsprechend ist ein erfindungsgemäßes Verfahren (vorzugsweise wie vorstehend als bevorzugt bezeichnet) bevorzugt, welches den Schritt umfasst:
- Applizieren von (i) Zink oder (ii) Zink und einem oder mehreren weiteren Metallen, auf die metallische Zwischenschicht, so dass eine die Zwischenschicht bedeckende Korrosionsschutzbeschichtung resultiert, deren Hauptbestandteil Zink ist
   oder
- Applizieren von (i) Mangan oder (ii) Mangan und einem oder mehreren weiteren Metallen, auf die metallische Zwischenschicht, so dass eine die Zwischenschicht bedeckende Korrosionsschutzbeschichtung resultiert, deren Hauptbestandteil Mangan ist.

Bevorzugt ist ein erfindungsgemäßes Verfahren (vorzugsweise wie vorstehend als bevorzugt bezeichnet), wobei das Applizieren von (i) Titan oder (ii) Titan und einem oder mehreren weiteren Metallen auf das Stahlsubstrat sowie das Applizieren von einem oder mehreren weiteren Metallen auf die metallische Zwischenschicht so durchgeführt wird, dass zumindest 90 % der dem Stahlsubstrat zugewandten Fläche der Korrosionsschutzbeschichtung durch die metallische Zwischenschicht vom Stahlsubstrat getrennt ist, bevorzugt zumindest 95 %, besonders bevorzugt die gesamte dem Stahlsubstrat zugewandte Fläche.

Es gelten die oben im Zusammenhang mit dem entsprechenden bevorzugten erfindungsgemäßen Bauteil dargelegten Vorteile und Effekte.

Bevorzugt ist ein erfindungsgemäßes Verfahren (vorzugsweise wie vorstehend als bevorzugt bezeichnet), wobei das Stahlsubstrat ein Mangan-Bor-Stahl und/oder ein Stahl mit ferritisch-perlitischem Gefüge ist, bevorzugt ein Mangan-Bor-Stahl mit ferritisch-perlitischem Gefüge ist, besonders bevorzugt ein Mangan-Bor-Stahl mit ferritisch-perlitischem Gefüge ist, welches durch thermische Härtungsbehandlung in ein martensitisches Gefüge umwandelbar ist, ganz besonders bevorzugt ein Mangan-Bor-Stahl mit ferritisch-perlitischem Gefüge und einem Anteil an Mangan von weniger als 5 Gew.-%, bevorzugt 0,7 bis 2 Gew.-% ist, welches durch thermische Härtungsbehandlung in ein martensitisches Gefüge umwandelbar ist.

Die vorstehend im Zusammenhang mit dem erfindungsgemäßen Bauteil dargelegten Effekte und Vorteile werden auch hier erreicht.

Die Erfindung betrifft ein erfindungsgemäßes Verfahren (vorzugsweise wie vorstehend als bevorzugt bezeichnet), wobei beim Applizieren von (i) Titan oder (ii) Titan und einem oder mehreren weiteren Metallen auf das Stahlsubstrat der Anteil an Titan so gewählt wird, dass in der resultierenden, das Stahlsubstrat bedeckenden metallischen Zwischenschicht der Anteil an Titan größer oder gleich 90 Gew.-% ist, bezogen auf die Gesamtmasse der Zwischenschicht.

Die vorstehend im Zusammenhang mit dem erfindungsgemäßen Bauteil dargelegten Effekte und Vorteile werden auch hier erreicht.

Bevorzugt ist ein erfindungsgemäßes Verfahren (vorzugsweise wie vorstehend als bevorzugt bezeichnet), wobei die Art und Menge der zur Herstellung der metallischen Zwischenschicht zu applizierenden Metalle so gewählt sind, dass das Material der resultierenden, das Stahlsubstrat bedeckenden metallischen Zwischenschicht, deren Hauptbestandteil Titan ist,
- einen Schmelzpunkt besitzt, der größer ist als 1000 °C, vorzugsweise größer als 1200 °C, bevorzugt größer als 1400 °C, besonders bevorzugt größer als 1600 °C
   und/oder
- einen Siedepunkt besitzt, der kleiner ist als 4700 °C, vorzugsweise kleiner ist als 3500 °C.

Es gelten die obigen Ausführungen entsprechend.

Besonders bevorzugt ist ein erfindungsgemäßes Verfahren (vorzugsweise wie vorstehend als bevorzugt bezeichnet), wobei
beim Applizieren von (i) Zink oder (ii) Zink und einem oder mehreren weiteren Metallen auf die metallische Zwischenschicht der Anteil an Zink so gewählt wird, dass der Anteil an Zink in derdie Zwischenschicht bedeckenden Korrosionsschutzbeschichtung größer oder gleich 55 Gew.-% ist, bezogen auf die Gesamtmasse der Korrosionsschutzbeschichtung
   oder
beim Applizieren von (i) Mangan oder (ii) Mangan und einem oder mehreren weiteren Metallen auf die metallische Zwischenschicht der Anteil an Mangan so gewählt wird, dass der Schmelzpunkt der Korrosionsschutzbeschichtung oder der Schmelzpunkt der einen bzw. zumindest der an der metallischen Zwischenschicht anliegenden metallischen Schicht der Korrosionsschutzbeschichtung größer als oder gleich 880 °C ist.

Bevorzugt ist ein erfindungsgemäßes Verfahren (vorzugsweise wie vorstehend als bevorzugt bezeichnet), umfassend das Applizieren von (ii) Zink und Mangan und gegebenenfalls einem oder mehreren weiteren Metallen auf die metallische Zwischenschicht, so dass eine die Zwischenschicht bedeckende Korrosionsschutzbeschichtung resultiert, deren Hauptbestandteil Zink ist und die Mangan umfasst,
wobei die zu applizierende Menge an Zink und Mangan und den gegebenenfalls ein oder mehr weiteren Metallen vorzugsweise so gewählt wird, dass die resultierende Korrosionsschutzbeschichtung einen Anteil an Mangan umfasst, der
   - bezogen auf die Gesamtmasse der resultierenden Korrosionsschutzbeschichtung im Bereich von 15 bis 40 Gew.-% liegt
      und/oder
   - bezogen auf die Gesamtmasse an Mangan und Zink in der resultierenden Korrosionsschutzbeschichtung
größer oder gleich 27 % ist, bevorzugt größer oder gleich 30 % ist,
   und/oder
kleiner 40 % ist, bevorzugt kleiner 35 % ist,
   und/oder
im Bereich von größer als 25 % bis 40 % liegt, bevorzugt im Bereich von größer als 25 % bis 35 %, besonders bevorzugt im Bereich von 27 % bis 35 %.

Es gelten die obigen Ausführungen entsprechend.

Bevorzugt ist ein erfindungsgemäßes Verfahren (vorzugsweise wie vorstehend als bevorzugt bezeichnet), wobei
die resultierende metallische Zwischenschicht, deren Hauptbestandteil Titan ist, eine Dicke von höchstens 500 nm besitzt, bevorzugt eine Dicke von höchstens 400 nm, besonders bevorzugt eine Dicke von höchstens 300 nm
   und/oder
die resultierende metallische Zwischenschicht, deren Hauptbestandteil Titan ist, eine Dicke von mindestens 100 nm, vorzugsweise mindestens 150 nm besitzt.

Es gelten die obigen Ausführungen entsprechend.

Bevorzugt ist ein erfindungsgemäßes Verfahren (vorzugsweise wie vorstehend als bevorzugt bezeichnet), wobei die resultierende Korrosionsschutzbeschichtung, deren Hauptbestandteil Zink ist, eine Dicke von zumindest 1 µm besitzt, vorzugsweise eine Dicke im Bereich von 3 µm bis 50 µm besitzt, bevorzugt eine Dicke im Bereich von 5 µm bis 30 µm besitzt, besonders bevorzugt im Bereich von 7 µm bis 20 µm besitzt.

Es gelten die obigen Ausführungen entsprechend.

Bevorzugt ist ein erfindungsgemäßes Verfahren (vorzugsweise wie vorstehend als bevorzugt bezeichnet), wobei
- das Applizieren von (i) Titan oder (ii) Titan und einem oder mehreren weiteren Metallen auf das Stahlsubstrat, sodass eine das Stahlsubstrat bedeckende metallische Zwischenschicht resultiert, deren Hauptbestandteil Titan ist
   und/oder
- das Applizieren von einem oder mehreren weiteren Metallen auf die metallische Zwischenschicht, sodass eine die Zwischenschicht bedeckende Korrosionsschutzbeschichtung resultiert,

mittels physikalischer Gasphasenabscheidung erfolgt. Diese physikalische Gasphasenabscheidung erfolgt dabei
vorzugsweise
   - bei einem Partialdruck von Sauerstoff von weniger als 0,1 mbar, bevorzugt weniger als 0,01 mbar, besonders bevorzugt weniger als 0,001 mbar
      und/oder
   - in einer Gasphase, in der der Volumenanteil des Sauerstoffs niedriger ist als 20 Vol.-%, vorzugsweise niedriger als 10 Vol.-%, besonders bevorzugt niedriger als 1 Vol.-%.

Offenbart wird auch ein Verfahren zum Herstellen eines gehärteten Bauteils mit folgenden Schritten:
- Bereitstellen eines erfindungsgemäßen Bauteils oder Herstellen eines Bauteils gemäß einem erfindungsgemäßen Verfahren (jeweils wie vorstehend und/oder in den beigefügten Ansprüchen definiert, vorzugsweise wie dort als bevorzugt bezeichnet),
- Behandeln des bereitgestellten oder hergestellten Bauteils, sodass das gehärtete Bauteil resultiert.

Es gelten die obigen Ausführungen zu bevorzugten erfindungsgemäßen Bauteilen und Verfahren sowie zu gehärteten Bauteilen entsprechend.

Bevorzugt ist somit ein solches Verfahren (vorzugsweise wie vorstehend als bevorzugt bezeichnet), wobei das bereitgestellte oder hergestellte Bauteil als Stahlsubstrat einen Stahl mit einem Gefüge umfasst, welches in ein martensitisches Gefüge umwandelbar ist, bevorzugt einen Stahl mit ferritisch-perlitischem Gefüge umfasst, besonders bevorzugt einen Mangan-Bor-Stahl mit ferritisch-perlitischem Gefüge, und das Behandeln umfasst:
eine thermische Härtungsbehandlung, bei der das Gefüge in ein martensitisches Gefüge umgewandelt wird,
und vorzugsweise
   - eine mechanische Behandlung, bevorzugt ein mechanisches Umformen, vor, während und/oder nach der thermischen Härtungsbehandlung (vorzugsweise während).
Bevorzugt ist ein solches Verfahren (vorzugsweise wie vorstehend als bevorzugt bezeichnet), wobei das Behandeln
zumindest die folgenden Schritte umfasst:
   (i) ein thermisches Behandeln, bei dem das Gefüge des Stahlsubstrats des bereitgestellten oder hergestellten Bauteils so lange bei einer Temperatur oberhalb von Ac3 gehalten wird, bis das Gefüge vollständig oder teilweise in ein austenitisches Gefüge umgewandelt ist,
   (ii) mechanisches Umformen des Bauteils, vor, während und/oder nach dem thermischen Behandeln,
   (iii) Abkühlen des Bauteils von der Temperatur oberhalb von Ac3, während und/oder nach dem mechanischen Umformen, bevorzugt auf eine Temperatur von weniger als 100 °C, sodass im Stahlsubstrat ein martensitisches Gefüge entsteht, vorzugsweise mit einer Abkühlrate > 20 K/s
   und/oder
den folgenden Schritt umfasst:
   mechanisches Behandeln, wobei die Porosität der Korrosionsschutzbeschichtung und/oder der metallischen Zwischenschicht verringert wird.

Offenbart ist auch die Verwendung von Titan als Hauptbestandteil einer Diffusionsbarriere zwischen einem Stahlsubstrat, dessen Gefüge in ein martensitisches Gefüge umwandelbar ist, und einer Korrosionsschutzbeschichtung, deren Hauptbestandteil Zink oder Mangan (vorzugsweise Zink) ist. Überraschenderweise hat sich gezeigt, dass die aus dem Stand der Technik bislang nicht bekannte Verwendung von Titan als Hauptbestandteil einer Diffusionsbarriere zu besonders hervorragenden Ergebnissen und technischen Effekten führt. Diese zeigen sich an einer drastisch verminderten Diffusion insbesondere bei Warmumformungsprozessen ausgehend von einem erfindungsgemäßen Bauteil hin zu einem gehärteten Bauteil.

Die im Zusammenhang mit erfindungsgemäßen Bauteilen, mit gehärteten Bauteilen und mit Verfahren genannten Vorteile und die dort dargelegten technischen Effekte gelten hinsichtlich der Verwendung entsprechend.

Bevorzugt ist eine Verwendung in einem Verfahren zur Herstellung eines gehärteten, vorzugsweise eines pressgehärteten Bauteils, bevorzugt eines pressgehärteten Bauteils eines Kraftfahrzeugs, besonders bevorzugt eines pressgehärteten Bauteils ausgewählt aus der Gruppe bestehend aus Stoßfängerquerträger, Seitenaufprallträ-ger, Säulen und Karosserieverstärkungen.

Schließlich wird auch die Verwendung eines erfindungsgemäßen Bauteils zum Herstellen eines gehärteten Bauteils offenbart.

Nachfolgend sind bevorzugte Aspekte der vorliegenden Erfindung bzw. der vorliegenden Offenbarung angegeben; die Bezugszeichen beziehen sich auf die beigefügten Zeichnungen, die weiter unten zudem näher erläutert werden.
1. Bauteil umfassend
   - ein Stahlsubstrat (3), dessen Gefüge in ein martensitisches Gefüge umwandelbar ist,
   - eine das Stahlsubstrat bedeckende metallische Zwischenschicht (2), deren Hauptbestandteil Titan ist
      und
   - eine die Zwischenschicht (2) bedeckende Korrosionsschutzbeschichtung (1),
   wobei die Korrosionsschutzbeschichtung (1) eine oder mehr Schichten umfasst und die eine bzw. zumindest die an der metallischen Zwischenschicht (2) anliegende Schicht der Korrosionsschutzbeschichtung (1) metallisch ist und sich stofflich von der Zwischenschicht (2) unterscheidet.
2. Bauteil nach Aspekt 1, wobei
   der Hauptbestandteil der Metallatome der Korrosionsschutzbeschichtung (1) bzw. der Hauptbestandteil der Metallatome der an der metallischen Zwischenschicht (2) anliegenden metallischen Schicht der Korrosionsschutzbeschichtung (1) ausgewählt ist aus der Gruppe bestehend aus Zink und Mangan
      und/oder
   metallisches Zink und/oder metallisches Mangan in der einen bzw. zumindest der an der metallischen Zwischenschicht (2) anliegenden metallischen Schicht der Korrosionsschutzbeschichtung (1) enthalten sind.
3. Bauteil nach einem der vorangehenden Aspekte, wobei zumindest 90 % der dem Stahlsubstrat (3) zugewandten Fläche der Korrosionsschutzbeschichtung (1) durch die metallische Zwischenschicht (2) vom Stahlsubstrat (3) getrennt ist, vorzugsweise zumindest 95 %, bevorzugt die gesamte dem Stahlsubstrat (3) zugewandte Fläche.
4. Bauteil nach einem der vorangehenden Aspekte, wobei das Stahlsubstrat (3) ein Mangan-Bor-Stahl und/oder ein Stahl mit ferritisch-perlitischem Gefüge ist,
   bevorzugt ein Mangan-Bor-Stahl mit ferritisch-perlitischem Gefüge ist,
   besonders bevorzugt ein Mangan-Bor-Stahl mit ferritisch-perlitischem Gefüge ist, welches durch thermische Härtungsbehandlung in ein martensitisches Gefüge umwandelbar ist,
   ganz besonders bevorzugt ein Mangan-Bor-Stahl mit ferritisch-perlitischem Gefüge und einem Anteil an Mangan von weniger als 5 Gew.-%, bevorzugt 0,7 bis 2 Gew.-% ist, welches durch thermische Härtungsbehandlung in ein martensitisches Gefüge umwandelbar ist.
5. Bauteil nach einem der vorangehenden Aspekte, wobei der Anteil an Titan in der das Stahlsubstrat (3) bedeckenden metallischen Zwischenschicht (2) größer oder gleich 90 Gew.-% ist, bezogen auf die Gesamtmasse der Zwischenschicht (2).
6. Bauteil nach einem der vorangehenden Aspekte, wobei das Material der das Stahlsubstrat bedeckenden metallischen Zwischenschicht (2), deren Hauptbestandteil Titan ist,
   - einen Schmelzpunkt besitzt, der größer ist als 1000 °C, vorzugsweise größer als 1200 °C, bevorzugt größer als 1400 °C, besonders bevorzugt größer als 1600 °C.
      und/oder
   - einen Siedepunkt besitzt, der kleiner ist als 4700 °C, vorzugsweise kleiner ist als 3500 °C.
7. Bauteil nach einem der vorangehenden Aspekte, wobei
   (i) metallisches Zink in der einen bzw. zumindest der an der metallischen Zwischenschicht (2) anliegenden metallischen Schicht der Korrosionsschutzbeschichtung (1) enthalten ist und
      - der Anteil an metallischem Zink in der die Zwischenschicht bedeckenden Korrosionsschutzbeschichtung (1) größer oder gleich 55 Gew.-% ist, vorzugsweise größer oder gleich 96 Gew.-% ist, bezogen auf die Gesamtmasse der Korrosionsschutzbeschichtung,
         und/oder
      - der Schmelzpunkt der Korrosionsschutzbeschichtung oder der Schmelzpunkt der einen bzw. zumindest der an der metallischen Zwischenschicht (2) anliegenden metallischen Schicht der Korrosionsschutzbeschichtung (1) größer als oder gleich 419 °C ist, vorzugsweise entweder im Bereich von 419 °C bis 580°C oder im Bereich größer 600 °C liegt
      oder
   (ii) der Schmelzpunkt der Korrosionsschutzbeschichtung oder der Schmelzpunkt der einen bzw. zumindest der an der metallischen Zwischenschicht (2) anliegenden metallischen Schicht der Korrosionsschutzbeschichtung (1) größer als oder gleich 880 °C ist.
8. Bauteil nach einem der vorangehenden Aspekte, wobei die Korrosionsschutzbeschichtung (1) einen Anteil an Mangan umfasst, der
   - bezogen auf die Gesamtmasse der Korrosionsschutzbeschichtung im Bereich von 15 bis 40 Gew.-% liegt
      und/oder
   - bezogen auf die Gesamtmasse an Mangan und Zink in der Korrosionsschutzbeschichtung
      größer oder gleich 27 % ist, bevorzugt größer oder gleich 30 % ist,
         und/oder
      kleiner 40 % ist, bevorzugt kleiner 35 % ist,
         und/oder
      im Bereich von größer als 25 % bis 40 % liegt, bevorzugt im Bereich von größer als 25 % bis 35 %, besonders bevorzugt im Bereich von 27 % bis 35%.
9. Bauteil nach einem der vorangehenden Aspekte, wobei
   die metallische Zwischenschicht (2), deren Hauptbestandteil Titan ist, eine Dicke von höchstens 500 nm besitzt, bevorzugt eine Dicke von höchstens 400 nm, besonders bevorzugt eine Dicke von höchstens 300 nm
      und/oder
   die metallische Zwischenschicht (2), deren Hauptbestandteil Titan ist, eine Dicke von mindestens 100 nm, vorzugsweise mindestens 150 nm besitzt.
10. Bauteil nach einem der vorangehenden Aspekte, wobei die Korrosionsschutzbeschichtung (1) eine Dicke von zumindest 1 µm besitzt, bevorzugt eine Dicke im Bereich von 3 µm bis 50 µm besitzt, besonders bevorzugt eine Dicke im Bereich von 5 µm bis 30 µm besitzt, ganz besonders bevorzugt im Bereich von 7 µm bis 20 µm besitzt.
11. Bauteil nach einem der vorangehenden Aspekte, wobei
   - die das Stahlsubstrat bedeckende metallische Zwischenschicht (2), deren Hauptbestandteil Titan ist,
      und/oder
   - die die Zwischenschicht bedeckende Korrosionsschutzbeschichtung (1) mittels physikalischer Gasphasenabscheidung appliziert ist bzw. sind.
12. Gehärtetes Bauteil, umfassend
   - ein Stahlsubstrat (6) und
   - eine das Stahlsubstrat schützende Korrosionsschutzbeschichtung (4), wobei die Korrosionsschutzbeschichtung Titan, vorzugsweise metallisches Titan umfasst.
13. Gehärtetes Bauteil nach Aspekt 12, wobei das gehärtete Bauteil
   erhältlich ist durch Härten eines Bauteils nach einem der Aspekte 1 bis 11
      und/oder
   ein warmumgeformtes gehärtetes Bauteil ist.
14. Gehärtetes Bauteil nach einem der Aspekte 12 bis 13, wobei das Stahlsubstrat (6) überwiegend ein martensitisches Gefüge besitzt.
15. Gehärtetes Bauteil nach einem der Aspekte 12 bis 14, wobei das Stahlsubstrat (6) in einer der Korrosionsschutzbeschichtung (4) zugewandten Zone mit Titan legiert ist, vorzugsweise mit Titan und zumindest einem Metall ausgewählt aus der Gruppe bestehend aus Zink und Mangan legiert ist.
16. Gehärtetes Bauteil nach einem der Aspekte 12 bis 15, wobei das Stahlsubstrat (6) und die Korrosionsschutzbeschichtung (4) durch eine Übergangszone (5) verbunden sind,
   - in der Eisen, Titan, und der metallische Hauptbestandteil der Korrosionsschutzbeschichtung vorliegen, wobei ausgehend von einem dem Stahlsubstrat nahen Bereich der Übergangszone in Richtung der Korrosionsschutzbeschichtung ein Wechsel des metallischen Hauptbestandteils erfolgt, von Eisen zum metallischen Hauptbestandteil der Korrosionsschutzbeschichtung, wobei der Hauptbestandteil der Korrosionsschutzbeschichtung vorzugsweise ausgewählt ist aus der Gruppe bestehend aus Zink und Mangan
      und/oder
   - in der sich der Massenanteil an Eisen, bestimmt mittels GDOES, ausgehend von einem dem Stahlsubstrat (6) nahen Bereich der Übergangszone (5) in Richtung der Korrosionsschutzbeschichtung (4), auf einer Strecke von höchstens 10 µm, vorzugsweise 5 µm, von einem ersten Massenanteil auf die Hälfte oder weniger als die Hälfte des ersten Anteils verringert, wobei der erste Massenanteil an Eisen in dem dem Stahlsubstrat (6) nahen Bereich der Übergangszone (5) bevorzugt zumindest 80 Gew.-% beträgt.
17. Gehärtetes Bauteil nach einem der Aspekte 12 bis 16, wobei in der Korrosionsschutzbeschichtung (4) in einer Tiefe von 2 µm, vorzugsweise im Bereich von 1 bis 3 µm, gemessen von der Außenfläche der Korrosionsschutzbeschichtung, der Anteil an Eisen niedriger ist als 25 Gew.-%, vorzugsweise niedriger ist als 20 Gew.-%, bestimmt mittels GDOES.
18. Gehärtetes Bauteil nach einem der Aspekte 12 bis 17, wobei für Titan im Massenanteil-Tiefe-Diagramm ein Maximum des Massenanteils, bestimmt mittels GDOES, in einer Tiefe > 0 µm vorliegt, vorzugsweise in einer Tiefe im Bereich von 2 bis 20 µm, gemessen von der Außenfläche der Korrosionsschutzbeschichtung (4).
19. Verfahren zum Herstellen eines Bauteils, vorzugsweise eines Bauteils nach einem der Aspekte 1 bis 12, mit folgenden Schritten:
   - Herstellen oder Bereitstellen eines Stahlsubstrats (3), wobei das Gefüge des Stahlsubstrats in ein martensitisches Gefüge umwandelbar ist,
   - Applizieren von (i) Titan oder (ii) Titan und einem oder mehreren weiteren Metallen auf das Stahlsubstrat, so dass eine das Stahlsubstrat bedeckende metallische Zwischenschicht (2) resultiert, deren Hauptbestandteil Titan ist,
   - Applizieren von einem oder mehreren Metallen auf die metallische Zwischenschicht, so dass eine die Zwischenschicht bedeckende Korrosionsschutzbeschichtung (1) resultiert.
20. Verfahren nach Aspekt 19, umfassend den Schritt
   - Applizieren von (i) Zink oder (ii) Zink und einem oder mehreren weiteren Metallen, auf die metallische Zwischenschicht, so dass eine die Zwischenschicht bedeckende Korrosionsschutzbeschichtung (1) resultiert, deren Hauptbestandteil Zink ist
      oder
   - Applizieren von (i) Mangan oder (ii) Mangan und einem oder mehreren weiteren Metallen, auf die metallische Zwischenschicht, so dass eine die Zwischenschicht bedeckende Korrosionsschutzbeschichtung (1) resultiert, deren Hauptbestandteil Mangan ist.
21. Verfahren nach Aspekt 19 oder 20, wobei das Applizieren von (i) Titan oder (ii) Titan und einem oder mehreren weiteren Metallen auf das Stahlsubstrat (3) sowie das Applizieren von einem oder mehreren weiteren Metallen auf die metallische Zwischenschicht (2) so durchgeführt wird, dass zumindest 90 % der dem Stahlsubstrat zugewandten Fläche der Korrosionsschutzbeschichtung (1) durch die metallische Zwischenschicht (2) vom Stahlsubstrat (3) getrennt ist, bevorzugt zumindest 95 %, besonders bevorzugt die gesamte dem Stahlsubstrat (3) zugewandte Fläche.
22. Verfahren nach einem der Aspekte 19 bis 21, wobei das Stahlsubstrat (3) ein Mangan-Bor-Stahl und/oder ein Stahl mit ferritisch-perlitischem Gefüge ist,
   bevorzugt ein Mangan-Bor-Stahl mit ferritisch-perlitischem Gefüge ist,
   besonders bevorzugt ein Mangan-Bor-Stahl mit ferritisch-perlitischem Gefüge ist, welches durch thermische Härtungsbehandlung in ein martensitisches Gefüge umwandelbar ist,
   ganz besonders bevorzugt ein Mangan-Bor-Stahl mit ferritisch-perlitischem Gefüge und einem Anteil an Mangan von weniger als 5 Gew.-%, bevorzugt 0,7 bis 2 Gew.-% ist, welches durch thermische Härtungsbehandlung in ein martensitisches Gefüge umwandelbar ist.
23. Verfahren nach einem der Aspekte 19 bis 22, wobei beim Applizieren von (i) Titan oder (ii) Titan und einem oder mehreren weiteren Metallen auf das Stahlsubstrat (3) der Anteil an Titan so gewählt wird, dass in der resultierenden, das Stahlsubstrat (3) bedeckenden metallischen Zwischenschicht (2) der Anteil an Titan größer oder gleich 90 Gew.-% ist, bezogen auf die Gesamtmasse der Zwischenschicht (2).
24. Verfahren nach einem der Aspekte 19 bis 23, wobei die Art und Menge der zur Herstellung der metallischen Zwischenschicht (2) zu applizierenden Metalle so gewählt sind, dass das Material der resultierenden, das Stahlsubstrat (3) bedeckenden metallischen Zwischenschicht (2), deren Hauptbestandteil Titan ist,
   - einen Schmelzpunkt besitzt, der größer ist als 1000 °C, vorzugsweise größer als 1200 °C, bevorzugt größer als 1400 °C, besonders bevorzugt größer als 1600 °C.
      und/oder
   - einen Siedepunkt besitzt, der kleiner ist als 4700 °C, vorzugsweise kleiner ist als 3500 °C.
25. Verfahren nach einem der Aspekte 19 bis 24, wobei
   beim Applizieren von (i) Zink oder (ii) Zink und einem oder mehreren weiteren Metallen auf die metallische Zwischenschicht (2) der Anteil an Zink so gewählt wird, dass der Anteil an Zink in der die Zwischenschicht (2) bedeckenden Korrosionsschutzbeschichtung (1) größer oder gleich 55 Gew.-% ist, bezogen auf die Gesamtmasse der Korrosionsschutzbeschichtung
      oder
   beim Applizieren von (i) Mangan oder (ii) Mangan und einem oder mehreren weiteren Metallen auf die metallische Zwischenschicht (2) der Anteil an Mangan so gewählt wird, dass der Schmelzpunkt der Korrosionsschutzbeschichtung oder der Schmelzpunkt der einen bzw. zumindest der an der metallischen Zwischenschicht (2) anliegenden metallischen Schicht der Korrosionsschutzbeschichtung (1) größer als oder gleich 880 °C ist.
26. Verfahren nach einem der Aspekte 19 bis 25, umfassend das Applizieren von (ii) Zink und Mangan und gegebenenfalls einem oder mehreren weiteren Metallen auf die metallische Zwischenschicht, so dass eine die Zwischenschicht bedeckende Korrosionsschutzbeschichtung (1) resultiert, deren Hauptbestandteil Zink ist und die Mangan umfasst,
   wobei die zu applizierende Menge an Zink und Mangan und den gegebenenfalls ein oder mehr weiteren Metallen vorzugsweise so gewählt wird, dass die
   resultierende Korrosionsschutzbeschichtung (1) einen Anteil an Mangan umfasst, der
      - bezogen auf die Gesamtmasse der resultierenden Korrosionsschutzbeschichtung (1) im Bereich von 15 bis 40 Gew.-% liegt
         und/oder
      - bezogen auf die Gesamtmasse an Mangan und Zink in der resultierenden Korrosionsschutzbeschichtung (1)
         größer oder gleich 27 % ist, bevorzugt größer oder gleich 30 % ist,
            und/oder
         kleiner 40 % ist, bevorzugt kleiner 35 % ist,
            und/oder
         im Bereich von größer als 25 % bis 40 % liegt, bevorzugt im Bereich von größer als 25 % bis 35 %, besonders bevorzugt im Bereich von 27 % bis 35 %.
27. Verfahren nach einem der Aspekte 19 bis 26, wobei
   die resultierende metallische Zwischenschicht (2), deren Hauptbestandteil Titan ist, eine Dicke von höchstens 500 nm besitzt, bevorzugt eine Dicke von höchstens 400 nm, besonders bevorzugt eine Dicke von höchstens 300 nm
      und/oder
   die resultierende metallische Zwischenschicht (2), deren Hauptbestandteil Titan ist, eine Dicke von mindestens 100 nm, vorzugsweise mindestens 150 nm besitzt.
28. Verfahren nach einem der Aspekte 19 bis 27, wobei die resultierende Korrosionsschutzbeschichtung (1), deren Hauptbestandteil Zink ist, eine Dicke von zumindest 1 µm besitzt, vorzugsweise eine Dicke im Bereich von 3 µm bis 50 µm besitzt, bevorzugt eine Dicke im Bereich von 5 µm bis 30 µm besitzt, besonders bevorzugt im Bereich von 7 µm bis 20 µm besitzt.
29. Verfahren nach einem der Aspekte 19 bis 28,
   wobei
   - das Applizieren von (i) Titan oder (ii) Titan und einem oder mehreren weiteren Metallen auf das Stahlsubstrat, sodass eine das Stahlsubstrat bedeckende metallische Zwischenschicht (2) resultiert, deren Hauptbestandteil Titan ist
   und/oder
   - das Applizieren von einem oder mehreren weiteren Metallen auf die metallische Zwischenschicht, sodass eine die Zwischenschicht bedeckende Korrosionsschutzbeschichtung (1) resultiert,

   mittels physikalischer Gasphasenabscheidung erfolgt,
   vorzugsweise
      - bei einem Partialdruck von Sauerstoff von weniger als 0,1 mbar, bevorzugt weniger als 0,01 mbar, besonders bevorzugt weniger als 0,001 mbar und/oder
      - in einer Gasphase, in der der Volumenanteil des Sauerstoffs niedriger ist als 20 Vol.-%, vorzugsweise niedriger als 10 Vol.-%, besonders bevorzugt niedriger als 1 Vol.-%.
30. Verfahren zum Herstellen eines gehärteten Bauteils, vorzugsweise eines gehärteten Bauteils nach einem der Aspekte 12 bis 18, mit folgenden Schritten:
   - Bereitstellen eines Bauteils nach einem der Aspekte 1 bis 12 oder Herstellen eines Bauteils gemäß einem Verfahren nach einem der Aspekte 20 bis 31,
   - Behandeln des bereitgestellten oder hergestellten Bauteils, sodass das gehärtete Bauteil resultiert.
31. Verfahren nach Aspekt 30, wobei das bereitgestellte oder hergestellte Bauteil als Stahlsubstrat (3) einen Stahl mit einem Gefüge umfasst, welches in ein martensitisches Gefüge umwandelbar ist, bevorzugt einen Stahl mit ferritisch-perlitischem Gefüge umfasst, besonders bevorzugt einen Mangan-Bor-Stahl mit ferritisch-perlitischem Gefüge, und das Behandeln umfasst:
   eine thermische Härtungsbehandlung, bei der das Gefüge in ein martensitisches Gefüge umgewandelt wird,
   und vorzugsweise
      - eine mechanische Behandlung, bevorzugt ein mechanisches Umformen, vor, während und/oder nach der thermischen Härtungsbehandlung.
32. Verfahren nach einem der Aspekte 30 bis 31, wobei das Behandeln
   zumindest die folgenden Schritte umfasst:
      (i) ein thermisches Behandeln, bei dem das Gefüge des Stahlsubstrats des bereitgestellten oder hergestellten Bauteils so lange bei einer Temperatur oberhalb von Ac3 gehalten wird, bis das Gefüge vollständig oder teilweise in ein austenitisches Gefüge umgewandelt ist,
      (ii) mechanisches Umformen des Bauteils, vor, während und/oder nach dem thermischen Behandeln,
      (iii) Abkühlen des Bauteils von der Temperatur oberhalb von Ac3, während und/oder nach dem mechanischen Umformen, bevorzugt auf eine Temperatur von weniger als 100 °C, sodass im Stahlsubstrat ein martensitisches Gefüge entsteht, vorzugsweise mit einer Abkühlrate > 20 K/s
         und/oder
   den folgenden Schritt umfasst:
      mechanisches Behandeln, wobei die Porosität der Korrosionsschutzbeschichtung und/oder der metallischen Zwischenschicht verringert wird.
33. Verwendung von Titan als Hauptbestandteil einer Diffusionsbarriere zwischen einem Stahlsubstrat (3), dessen Gefüge in ein martensitisches Gefüge umwandelbar ist, und einer Korrosionsschutzbeschichtung (1), deren Hauptbestandteil Zink oder Mangan ist.
34. Verwendung nach Aspekt 33, in einem Verfahren zur Herstellung eines gehärteten, vorzugsweise eines pressgehärteten Bauteils, bevorzugt eines pressgehärteten Bauteils eines Kraftfahrzeugs, besonders bevorzugt eines pressgehärteten Bauteils ausgewählt aus der Gruppe bestehend aus Stoßfängerquerträger, Seitenaufprallträger, Säulen und Karosserieverstärkungen.
35. Verwendung eines Bauteils nach einem der Aspekte 1 bis 11 zum Herstellen eines gehärteten Bauteils nach einem der Aspekte 12 bis 18.

### Abbildungen

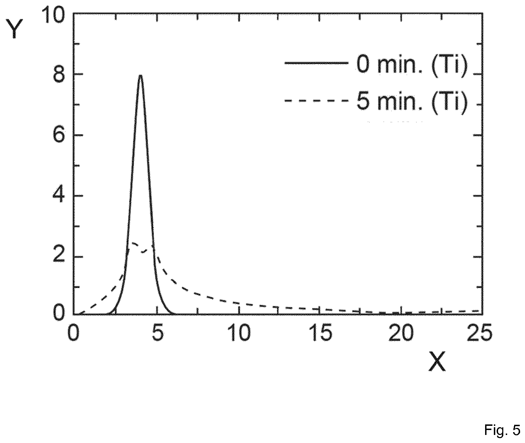

- Fig. 1: zeigt schematisch ein erfindungsgemäßes Bauteil mit einem Stahlsubstrat (3), dessen Gefüge in ein martensitisches Gefüge umwandelbar ist, einer das Stahlsubstrat bedeckenden metallischen Zwischenschicht (2), deren Hauptbestandteil Titan ist, sowie einer die Zwischenschicht (2) bedeckenden Korrosionsschutzbeschichtung (1). Details für ein beispielhaftes erfindungsgemäßes Bauteil ergeben sich aus Beispiel 1, unten.
- Fig. 2: zeigt schematisch ein gehärtetes Bauteil wie es nach einer thermischen Behandlung (Warmumformung) eines erfindungsgemäßen Bauteils vorliegt, wobei das Stahlsubstrat (6) und die Korrosionsschutzbeschichtung (4) durch eine Übergangszone (5) verbunden sind. Vergleiche Beispiel 2, unten.
- Fig. 3, Fig. 4 und Fig. 5: sind zusammenfassende zeichnerische Darstellungen auf Basis exemplarischer experimenteller Rohdaten.
- Fig. 3: zeigt die Ergebnisse von GDOES-Messungen (nach ISO 11505:2012) an einem erfindungsgemäßen Bauteil, einem weiteren gehärteten Bauteil und - zum Vergleich - einem nicht erfindungsgemäßen gehärteten Bauteil für das Element Eisen (Fe). Die X-Achse gibt die Entfernung von der Probenoberfläche (d.h. die Tiefe) in Mikrometer an. Die Y-Achse gibt den Massenanteil an Eisen (in Prozent) in dem jeweils untersuchten Volumen der Probe an.
Die Volllinie [ 0 min. (Ti) ] stellt Messwerte dar, die an einem erfindungsgemäßen Bauteil (mit Zwischenschicht aus Titan) bestimmt wurden. Als Stahlsubstrat wurde ein 22MnB5-Substrat eingesetzt, die das Stahlsubstrat bedeckende metallische Zwischenschicht (2), deren Hauptbestandteil Titan ist, bestand aus Titan (lediglich enthaltend unvermeidliche Verunreinigungen) und die die Zwischenschicht (2) bedeckende Korrosionsschutzbeschichtung (1) bestand aus Zink (lediglich enthaltend unvermeidliche Verunreinigungen). Die Volllinie in Fig. 3 korrespondiert mit den Volllinien in Fig. 4 und Fig. 5; die den Volllinien in Fig. 3, Fig. 4 und Fig. 5 zugrundeliegenden Messpunkte entstammen jeweils einer gemeinsamen GDOESMessung.
Die Strichlinie [ 5 min. (Ti) ] stellt Messwerte dar, die an einem gehärteten Bauteil bestimmt wurden. Das vermessene gehärtete Bauteil wurde durch Warmumformung bei 880°C mit einer Haltedauer von 5 Minuten aus einem erfindungsgemäβen Bauteil erhalten. Die Strichlinie in Fig. 3 korrespondiert mit den Strichlinien in Fig. 4 und Fig. 5; die den Strichlinien in Fig. 3, Fig. 4 und Fig. 5 zugrundeliegenden Messpunkte entstammen jeweils einer gemeinsamen GDOES-Messung.
Die Strichpunktlinie [ 5 min. ] stellt Messwerte dar, die an einem weiteren gehärteten Bauteil gemessen wurden welches durch Warmumformung bei 880 °C mit einer Haltedauer von 5 Minuten aus einem entsprechenden nicht erfindungsgemäβen Bauteil (ohne Titan-Zwischenschicht) erhalten wurde. Das Stahlsubstrat (3) ist hier beispielhaft ein 22MnB5-Substrat; eine das Stahlsubstrat bedeckende metallische Zwischenschicht (2) war hier nicht vorhanden, stattdessen kontaktierte die Korrosionsschutzbeschichtung (1), hier beispielhaft bestehend aus Zink, unmittelbar das Stahlsubstrat. Untersuchungsergebnisse zu einem entsprechenden nicht erfindungsgemäßen Bauteil sind in Fig. 3 nicht enthalten. Die Strichpunktlinie in Fig. 3 korrespondiert mit der Strichpunktlinie in Fig. 4; die den Strichpunktlinien in Fig. 3 und Fig. 4 zugrundeliegenden Messpunkte entstammen jeweils einer gemeinsamen GDOES-Messung.
- Fig. 4: zeigt die Ergebnisse von GDOES-Messungen (nach ISO 11505:2012) an einem erfindungsgemäßen Bauteil, einem weiteren gehärteten Bauteil und - zum Vergleich - einem nicht erfindungsgemäßen gehärteten Bauteil für das Element Zink (Zn). Die X-Achse gibt die Entfernung von der Probenoberfläche (d.h. die Tiefe) in Mikrometer an. Die Y-Achse gibt den Massenanteil an Zink (in Prozent) in dem jeweils untersuchten Volumen der Probe an.
Die Volllinie [ 0 min. (Ti) ] stellt Messwerte dar, die an einem erfindungsgemäßen Bauteil (mit Zwischenschicht aus Titan) bestimmt wurden. Als Stahlsubstrat wurde ein 22MnB5-Substrat eingesetzt, die das Stahlsubstrat bedeckende metallische Zwischenschicht (2), deren Hauptbestandteil Titan ist bestand aus Titan (lediglich enthaltend unvermeidliche Verunreinigungen) und die die Zwischenschicht (2) bedeckende Korrosionsschutzbeschichtung (1) bestand aus Zink (lediglich enthaltend unvermeidliche Verunreinigungen).
Die Strichlinie [ 5 min. (Ti) ] stellt Messwerte dar, die an einem gehärteten Bauteil bestimmt wurden. Das vermessene gehärtete Bauteil wurde durch Warmumformung bei 880°C mit einer Haltedauer von 5 Minuten aus einem erfindungsgemäβen Bauteil erhalten.
Die Strichpunktlinie [ 5 min. ] stellt Messwerte dar, die an einem weiteren gehärteten Bauteil gemessen wurden welches durch Warmumformung bei 880 °C mit einer Haltedauer von 5 Minuten aus einem entsprechenden Bauteil erhalten wurde.
Das Stahlsubstrat (3) ist hier beispielhaft ein 22MnB5-Substrat; eine das Stahlsubstrat bedeckende metallische Zwischenschicht (2) war hier nicht vorhanden, stattdessen kontaktierte die Korrosionsschutzbeschichtung (1), hier beispielhaft bestehend aus Zink, unmittelbar das Stahlsubstrat. Untersuchungsergebnisse zu einem entsprechenden nicht erfindungsgemäßen Bauteil sind in Fig. 4. nicht enthalten.
- Fig. 5: zeigt die Ergebnisse von GDOES-Messungen (nach ISO 11505:2012) an einem erfindungsgemäßen Bauteil und einem gehärteten Bauteil für das Element Titan (Ti). Die X-Achse gibt die Entfernung von der Probenoberfläche (d.h. die Tiefe) in Mikrometer an. Die Y-Achse gibt den Massenanteil an Titan (in Prozent) in dem jeweils untersuchten Volumen der Probe an.
Die Volllinie [ 0 min. (Ti) ] stellt Messwerte dar, die an einem erfindungsgemäßen Bauteil (mit Zwischenschicht aus Titan) bestimmt wurden. Als Stahlsubstrat wurde ein 22MnB5-Substrat eingesetzt, die das Stahlsubstrat bedeckende metallische Zwischenschicht (2), deren Hauptbestandteil Titan ist, bestand aus Titan (lediglich enthaltend unvermeidliche Verunreinigungen) und die die Zwischenschicht (2) bedeckende Korrosionsschutzbeschichtung (1) bestand aus Zink (lediglich enthaltend unvermeidliche Verunreinigungen). Die Volllinie in Fig. 5 korrespondiert mit den Volllinien in Fig. 3 und Fig. 4; die den Volllinien in Fig. 3, Fig. 4 und Fig. 5 zugrundeliegenden Messpunkte entstammen jeweils einer gemeinsamen GDOES-Messung.
Die Strichlinie [ 5 min. (Ti) ] stellt Messwerte dar, die an einem gehärteten Bauteil bestimmt wurden. Das vermessene gehärtete Bauteil wurde durch Warmumformung bei 880°C mit einer Haltedauer von 5 Minuten aus einem erfindungsgemäßen Bauteil erhalten.

### Beispiel 1 - Herstellung und Untersuchung eines erfindungsgemäßen Bauteils

Auf ein bereitgestelltes 22MnB5-Substrat (Mangan-Bor-Stahl mit ferritisch-perlitischem Gefüge, als Beispiel eines Stahlsubstrats, dessen Gefüge in ein martensitisches Gefüge umwandelbar ist) wurde mittels physikalischer Gasphasenabscheidung (PVD) eine metallische Zwischenschicht aus Ti in einer Dicke von ca. 250 nm appliziert (als Beispiel für eine das Stahlsubstrat bedeckende metallische Zwischenschicht, deren Hauptbestandteil Ti ist). Das Applizieren mittels physikalischer Gasphasenabscheidung erfolgte bei einem Partialdruck von Sauerstoff von weniger als 0.001 mbar. Dabei wurde das Applizieren der metallischen Zwischenschicht aus Titan mittels physikalischer Gasphasenabscheidung so gesteuert, dass zumindest 95% der Fläche des Stahlsubstrats mit der metallischen Zwischenschicht bedeckt wurden.

Auf diese metallische Zwischenschicht wurde eine einzelne ca. 5 µm dicke Zn-Schicht appliziert (als Beispiel für eine die Zwischenschicht bedeckende Korrosionsschutzbeschichtung; die Verwendung von Mangan oder von Zink-Mangan-Legierungen ist gleichermaßen vorteilhaft, wie eigene Untersuchungen gezeigt haben).

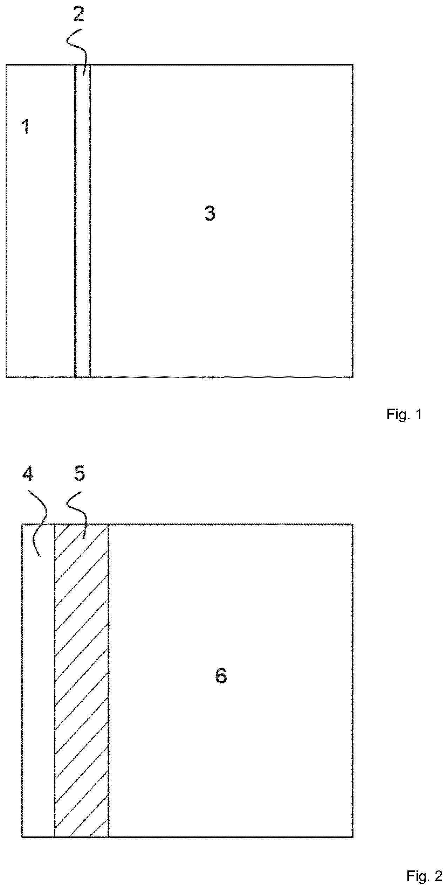

Fig. 1 zeigt schematisch den resultierenden Aufbau des beispielhaft hergestellten Bauteils mit dem Stahlsubstrat (3), der das Stahlsubstrat bedeckenden metallischen Zwischenschicht (2), deren Hauptbestandteil Titan ist, sowie der die Zwischenschicht (2) bedeckenden Korrosionsschutzbeschichtung (1). Die Beschichtung der metallischen Zwischenschicht mit der Korrosionsschutzbeschichtung erfolgte hier so, dass zumindest 95 % der dem Stahlsubstrat (3) zugewandten Fläche der Korrosionsschutzbeschichtung (1) an der metallischen Zwischenschicht (2) anlag und dadurch vom Stahlsubstrat (3) getrennt war.

Die beschriebene Vorgehensweise steht beispielhaft für ein erfindungsgemäßes Verfahren zur Herstellung eines erfindungsgemäßen Bauteils.

Das so erhaltene Bauteil wurde mittels GDOES-Messungen untersucht; die Ergebnisse sind in Fig. 3, Fig. 4 und Fig. 5 als Volllinien (für Eisen, Zink beziehungsweise Titan) dargestellt.

Die Messwerte zeigen, dass Zink an der Bauteiloberfläche als einziges Metall detektiert wird und ab einer Tiefe von etwa 5 µm nicht mehr detektiert wird. Eisen wird erst ab einer Probentiefe von etwa 3 µm detektiert und liegt ab einer Tiefe von etwa 5 µm als einziges der hier betrachteten Metalle vor.

Die Messwerte für Titan (als Material der Zwischenschicht) weisen ein Maximum bei einer Tiefe von etwa 4 µm auf. Der mittels GDOES ermittelte Massenanteil des Titans erreicht dabei keine 100%; dies ist insbesondere auf die, im Verhältnis zur Schichtdicke, große laterale Ausdehnung des Messfleckes (Durchmesser ca. 4 mm) zurückzuführen, wodurch sich das Signal bezüglich der Tiefenauflösung erheblich verbreitert. Titan wird im Ergebnis aufgrund der gewählten Messmethode im jeweils beprobten Volumen in seinem relativen Massenanteil unterbewertet.

Nicht überall entlang des Tiefenprofils addieren sich die Massenanteile der aufgetragenen Elemente Eisen, Zink und Titan zu 100%. Grund hierfür ist insbesondere, dass das Zink insbesondere an der Oberfläche oxidiert, dort also auch noch Sauerstoff in der Schicht existiert. Der Sauerstoffanteil ist in den Figuren 3, 4 und 5 aus Gründen der Übersichtlichkeit nicht dargestellt.

### Beispiel 2 - Herstellung und Untersuchung eines gehärteten Bauteils

### 2.1 Herstellung eines erfindungsgemäßen Bauteils:

Es wurde zunächst ein Bauteil hergestellt, dass sich von dem in Beispiel 1 beschriebenen Bauteil lediglich hinsichtlich der Dicke der Zn-Korrosionsschutzbeschichtung unterscheidet; abweichend von der in Beispiel 1 gewählten Dicke der Zn-Korrosionsschutzbeschichtung von ca. 5 µm wurde eine Dicke von ca. 10 µm für die Zn-Korrosionsschutzbeschichtung gewählt. Dieses Vorgehen diente einer besseren Vergleichbarkeit der Analyseergebnisse, denn die Dicke einer mittels PVD applizierten Zn-Korrosionsschutzbeschichtung reduzierte sich durch Komprimierung (unter Reduktion der Porosität) sowie Abdampfung von Zink im Warmumformprozess in eigenen Untersuchungen etwa auf die Hälfte. So entsprechen die Dicken der Zn-Korrosionsschutzbeschichtung des Bauteils aus Beispiel 1 (ohne Warmumformung) und des gehärteten Bauteils aus Beispiel 2 (nach der Warmumformung) einander in etwa.

### 2.2 Herstellung des gehärteten Bauteils durch Warmumformung

Das gemäß 2.1 hergestellte erfindungsgemäße Bauteil wurde in einem Warmumformungsprozess bei 880°C und mit einer beispielhaften Haltedauer von 5 Minuten (so dass vollständig oder teilweise ein austenitisches Gefüge im Stahlsubstrat entsteht), sowie anschließendem Abkühlen zu einem erfindungsgemäßen gehärteten Bauteil mit einem martensitischen Gefüge gehärtet. Schematisch zeigt Fig. 2 den Aufbau des resultierenden gehärteten Bauteils.

### 2.3. GDOES - Untersuchungen

Das gehärtete Bauteil wurde mittels GDOES untersucht, die Ergebnisse sind in Fig. 3, Fig. 4 und Fig. 5 als Strichlinie dargestellt. Die Messergebnisse zeigen das Vorliegen einer Übergangszone im erfindungsgemäßen Bauteil, in der Eisen, Titan und Zink vorliegen, wobei ausgehend von einem dem Stahlsubstrat nahen Bereich der Übergangszone in Richtung der Korrosionsschutzbeschichtung ein Wechsel des metallischen Hauptbestandteils erfolgt, von Eisen zum Zink. Die Übergangszone verbindet Stahlsubstrat und Korrosionsschutzbeschichtung. Diese Eigenschaften der (sehr schmalen, hier etwa 5 µm dicken) Übergangszone sind dabei auf die hervorragende Diffusionsbarrierewirkung der metallischen Zwischenschicht aus Titan zurückzuführen, die im erfindungsgemäßen Bauteil vorlag (vergleiche Punkt 2.1). Die Messungen verdeutlichen, dass in der dem Stahlsubstrat zugewandten Zone der Übergangszone Eisen, Zink und Titan legiert vorliegen (gleichermaßen vorteilhaft kann erfindungsgemäß statt Zink oder zusätzlich zu Zink auch Mangan Bestandteil dieser Legierung sein, wenn es als Bestandteil der Korrosionsschutzbeschichtung gewählt wird). Der Massenanteil von Eisen in einer Tiefe von ca. 2 µm, gemessen von der Außenfläche der Korrosionsschutzbeschichtung, liegt bei unter 5 % (vergleiche Fig. 3). Der Massenanteil von Titan besitzt ein Maximum in einer Tiefe zwischen 3 und 5 µm, gemessen von der Außenfläche der Korrosionsschutzbeschichtung (vergleiche Fig. 5).

### 2.4. Vergleich / Bewertung / Fazit:

Im Vergleich mit Vergleichsbauteilen beziehungsweise gehärteten Vergleichsbauteilen, die bei ansonsten analogem Aufbau keine Zwischenschicht (Diffusionsbarriere) aus Titan bzw. keine Übergangszone enthielten, zeichnen sich die aus erfindungsgemäßen Bauteilen hergestellten Produkte insbesondere dadurch aus, dass das Eindringen des Zinks in das Stahlsubstrat drastisch verringert war. Gleichzeitig war in den aus erfindungsgemäßen Bauteilen hergestellten Produkten das Vordringen von Eisen aus dem Stahlsubstrat in die Korrosionsschutzbeschichtung drastisch reduziert. Typische Kurvenverläufe für Vergleichsprodukte (ohne Zwischenschicht) sind in den Figuren 3 und 4 eingetragen, jeweils für eine Warmumformung bei 880°C mit einer Haltedauer von 5 Minuten. Der Fachmann erkennt, dass die wechselseitige Durchdringung von Zink und Eisen in den Vergleichsprodukten sehr viel deutlicher ausgeprägt war als in den aus erfindungsgemäßen Bauteilen hergestellten Produkten. In den aus erfindungsgemäßen Bauteilen hergestellten Produkten hat somit die Zwischenschicht (Diffusionsbarriere) aus Titan eine solche wechselseitige Durchdringung weitgehend verhindert.

### Beispiel 3

Das in Beispiel 2.2 erstellte und gemäß Beispiel 2.3 mittels GDOES analysierte gehärtete Bauteil wurde ergänzend nasschemisch analysiert. Dazu wurde die Korrosionsschutzbeschichtung in Säure gelöst und im Anschluss mittels IPC-OES (Inductively coupled plasma optical emission spectrometry, Optische Emissionsspektrometrie mit induktiv gekoppeltem Plasma) nach DIN EN ISO 11885:2009-09 analysiert. Der Anteil an Fe in der Korrosionsschutzbeschichtung (nach 5 Minuten Glühdauer) wurde zu (3,2 ± 0,1) Gew.-% ermittelt, bezogen auf die betrachteten Elemente Zink, Eisen, Aluminium, Titan und Mangan. Auch dieses Ergebnis zeigt deutlich, dass die metallische Zwischenschicht aus Titan eine Eisendiffusion aus dem Stahlsubstrat in die Korrosionsschutzbeschichtung zumindest weitgehend verhinderte.

## Patentansprüche

1. Bauteil umfassend
- ein Stahlsubstrat (3), dessen Gefüge in ein martensitisches Gefüge umwandelbar ist,
- eine das Stahlsubstrat bedeckende metallische Zwischenschicht (2), deren Hauptbestandteil Titan ist
und
- eine die Zwischenschicht (2) bedeckende Korrosionsschutzbeschichtung (1),
wobei die Korrosionsschutzbeschichtung (1) eine oder mehr Schichten umfasst und die eine bzw. zumindest die an der metallischen Zwischenschicht (2) anliegende Schicht der Korrosionsschutzbeschichtung (1) metallisch ist und sich stofflich von der Zwischenschicht (2) unterscheidet,
und
wobei der Anteil an Titan in der das Stahlsubstrat (3) bedeckenden metallischen Zwischenschicht (2) größer oder gleich 90 Gew.-% ist, bezogen auf die Gesamtmasse der Zwischenschicht (2),
und
wobei die metallische Zwischenschicht (2), deren Hauptbestandteil Titan ist, eine Dicke von mindestens 100 nm besitzt.

2. Bauteil nach Anspruch 1, wobei
der Hauptbestandteil der Metallatome der Korrosionsschutzbeschichtung (1) bzw. der Hauptbestandteil der Metallatome der an der metallischen Zwischenschicht (2) anliegenden metallischen Schicht der Korrosionsschutzbeschichtung (1) ausgewählt ist aus der Gruppe bestehend aus Zink und Mangan
und/oder
metallisches Zink und/oder metallisches Mangan in der einen bzw. zumindest der an der metallischen Zwischenschicht (2) anliegenden metallischen Schicht der Korrosionsschutzbeschichtung (1) enthalten sind.

3. Bauteil nach einem der vorangehenden Ansprüche, wobei zumindest 90 % der dem Stahlsubstrat (3) zugewandten Fläche der Korrosionsschutzbeschichtung (1) durch die metallische Zwischenschicht (2) vom Stahlsubstrat (3) getrennt ist, vorzugsweise zumindest 95 %, bevorzugt die gesamte dem Stahlsubstrat (3) zugewandte Fläche.

4. Bauteil nach einem der vorangehenden Ansprüche,
(ii) wobei das Material der das Stahlsubstrat bedeckenden metallischen Zwischenschicht (2), deren Hauptbestandteil Titan ist,
- einen Schmelzpunkt besitzt, der größer ist als 1000 °C, vorzugsweise größer als 1200 °C, bevorzugt größer als 1400 °C, besonders bevorzugt größer als 1600 °C
und/oder
- einen Siedepunkt besitzt, der kleiner ist als 4700 °C, vorzugsweise kleiner ist als 3500 °C
und/oder
(iii) wobei
- die metallische Zwischenschicht (2), deren Hauptbestandteil Titan ist, eine Dicke von höchstens 500 nm besitzt, bevorzugt eine Dicke von höchstens 400 nm, besonders bevorzugt eine Dicke von höchstens 300 nm
und/oder
- die metallische Zwischenschicht (2), deren Hauptbestandteil Titan ist, eine Dicke von mindestens 150 nm besitzt.

5. Bauteil nach einem der vorangehenden Ansprüche, wobei
(i) metallisches Zink in der einen bzw. zumindest der an der metallischen Zwischenschicht (2) anliegenden metallischen Schicht der Korrosionsschutzbeschichtung (1) enthalten ist und
- der Anteil an metallischem Zink in der die Zwischenschicht bedeckenden Korrosionsschutzbeschichtung (1) größer oder gleich 55 Gew.-% ist, vorzugsweise größer oder gleich 96 Gew.-% ist, bezogen auf die Gesamtmasse der Korrosionsschutzbeschichtung
und/oder
- der Schmelzpunkt der Korrosionsschutzbeschichtung oder der Schmelzpunkt der einen bzw. zumindest der an der metallischen Zwischenschicht (2) anliegenden metallischen Schicht der Korrosionsschutzbeschichtung (1) größer als oder gleich 419 °C ist, vorzugsweise entweder im Bereich von 419 °C bis 580°C oder im Bereich größer 600 °C liegt
oder
(ii) der Schmelzpunkt der Korrosionsschutzbeschichtung oder der Schmelzpunkt der einen bzw. zumindest der an der metallischen Zwischenschicht (2) anliegenden metallischen Schicht der Korrosionsschutzbeschichtung (1) größer als oder gleich 880 °C ist.

6. Verfahren zum Herstellen eines Bauteils nach einem der Ansprüche 1 bis 5, mit folgenden Schritten:
- Herstellen oder Bereitstellen eines Stahlsubstrats (3), wobei das Gefüge des Stahlsubstrats in ein martensitisches Gefüge umwandelbar ist,
- Applizieren von (i) Titan oder (ii) Titan und einem oder mehreren weiteren Metallen auf das Stahlsubstrat, so dass eine das Stahlsubstrat bedeckende metallische Zwischenschicht (2) resultiert, deren Hauptbestandteil Titan ist,
- Applizieren von einem oder mehreren Metallen auf die metallische Zwischenschicht, so dass eine die Zwischenschicht bedeckende Korrosionsschutzbeschichtung (1) resultiert.

7. Verfahren nach Anspruch 6,
- wobei das Applizieren von (i) Titan oder (ii) Titan und einem oder mehreren weiteren Metallen auf das Stahlsubstrat (3) sowie das Applizieren von einem oder mehreren weiteren Metallen auf die metallische Zwischenschicht (2) so durchgeführt wird, dass zumindest 90 % der dem Stahlsubstrat zugewandten Fläche der Korrosionsschutzbeschichtung (1) durch die metallische Zwischenschicht (2) vom Stahlsubstrat (3) getrennt ist, bevorzugt zumindest 95 %, besonders bevorzugt die gesamte dem Stahlsubstrat (3) zugewandte Fläche
und/oder
- wobei beim Applizieren von (i) Titan oder (ii) Titan und einem oder mehreren weiteren Metallen auf das Stahlsubstrat (3) der Anteil an Titan so gewählt wird, dass in der resultierenden, das Stahlsubstrat (3) bedeckenden metallischen Zwischenschicht (2) der Anteil an Titan größer odergleich 90 Gew.-% ist, bezogen auf die Gesamtmasse der Zwischenschicht (2)
und/oder
- wobei die resultierende metallische Zwischenschicht (2), deren Hauptbestandteil Titan ist, eine Dicke von höchstens 500 nm besitzt, bevorzugt eine Dicke von höchstens 400 nm, besonders bevorzugt eine Dicke von höchstens 300 nm
und/oder
- wobei die resultierende metallische Zwischenschicht (2), deren Hauptbestandteil Titan ist, eine Dicke von mindestens 100 nm, vorzugsweise mindestens 150 nm besitzt.

8. Verfahren nach einem der Ansprüche 6 bis 7,
wobei
- das Applizieren von (i) Titan oder (ii) Titan und einem oder mehreren weiteren Metallen auf das Stahlsubstrat, sodass eine das Stahlsubstrat bedeckende metallische Zwischenschicht (2) resultiert, deren Hauptbestandteil Titan ist
und/oder
- das Applizieren von einem oder mehreren weiteren Metallen auf die metallische Zwischenschicht, sodass eine die Zwischenschicht bedeckende Korrosionsschutzbeschichtung (1) resultiert,
mittels physikalischer Gasphasenabscheidung erfolgt,
vorzugsweise
- bei einem Partialdruck von Sauerstoff von weniger als 0,1 mbar, bevor-zugt weniger als 0,01 mbar, besondres bevorzugt weniger als 0,001 mbar
und/oder
- in einer Gasphase, in der der Volumenanteil des Sauerstoffs niedriger ist als 20 Vol.-%, vorzugsweise niedriger als 10 Vol.-%, besonders bevorzugt niedriger als 1 Vol.-%.

## Claims

1. Component comprising
- a steel substrate (3) whose structure can be transformed into a martensite structure,
- a metallic intermediate layer (2) which covers the steel substrate and whose main constituent is titanium
and
- an anticorrosion coating (1) covering the intermediate layer (2),
wherein the anticorrosion coating (1) comprises one or more layers and the one layer or at least the layer of the anticorrosion coating (1) adjoining the metallic intermediate layer (2) is metallic and differs in terms of material from the intermediate layer (2),
and
wherein the proportion of titanium in the metallic intermediate layer (2) covering the steel substrate (3) is greater than or equal to 90% by weight, based on the total mass of the intermediate layer (2),
and
wherein the metallic intermediate layer (2) whose main constituent is titanium has a thickness of at least 100 mm.

2. Component according to Claim 1, wherein
the main constituent of the metal atoms of the anticorrosion coating (1) or the main constituent of the metal atoms of the metallic layer of the anticorrosion coating (1) adjoining the metallic intermediate layer (2) is selected from the group consisting of zinc and manganese
and/or
metallic zinc and/or metallic manganese are present in the one metallic layer or at least the metallic layer of the anticorrosion coating (1) adjoining the metallic intermediate layer (2).

3. Component according to either of the preceding claims, wherein at least 90% of the area of the anticorrosion coating (1) facing the steel substrate (3) is separated from the steel substrate (3) by the metallic intermediate layer (2), preferably at least 95%, more preferably the entire area facing the steel substrate (3).

4. Component according to any of the preceding claims,
(ii) wherein the material of the metallic intermediate layer (2) covering the steel substrate and whose main constituent is titanium
- has a melting point which is greater than 1000°C, preferably greater than 1200°C, more preferably greater than 1400°C, particularly preferably greater than 1600°C
and/or
- has a boiling point which is less than 4700°C, preferably less than 3500°C
and/or
(iii) wherein
- the metallic intermediate layer (2) whose main constituent is titanium has a thickness of not more than 500 nm, preferably a thickness of not more than 400 nm, particularly preferably a thickness of not more than 300 nm
and/or
- the metallic intermediate layer (2) whose main constituent is titanium has a thickness of at least 150 nm.

5. Component according to any of the preceding claims, wherein
(i) metallic zinc is present in the one metallic layer or at least the metallic layer of the anticorrosion coating (1) adjoining the metallic intermediate layer (2) and
- the proportion of metallic zinc in the anticorrosion coating (1) covering the intermediate layer is greater than or equal to 55% by weight, preferably greater than or equal to 96% by weight, based on the total mass of the anticorrosion coating
and/or
- the melting point of the anticorrosion coating or the melting point of the one metallic layer or at least the metallic layer of the anticorrosion coating (1) adjoining the metallic intermediate layer (2) is greater than or equal to 419°C, preferably either in the range from 419°C to 580°C or in the range above 600°C
or
(ii) the melting point of the anticorrosion coating or the melting point of the one metallic layer or at least the metallic layer of the anticorrosion coating (1) adjoining the metallic intermediate layer (2) is greater than or equal to 880°C.

6. Process for producing a component according to any of Claims 1 to 5, comprising steps as follows:
- production or provision of a steel substrate (3), where the structure of the steel substrate can be transformed into a martensite structure,
- application of (i) titanium or (ii) titanium and one or more further metals to the steel substrate so as to result in a metallic intermediate layer (2) which covers the steel substrate and whose main constituent is titanium,
- application of one or more metals to the metallic intermediate layer so as to result in an anticorrosion coating (1) covering the intermediate layer.

7. Process according to Claim 6,
- wherein the application of (i) titanium or (ii) titanium and one or more further metals to the steel substrate (3) and the application of one or more further metals to the metallic intermediate layer (2) is carried out in such a way that at least 90% of the area of the anticorrosion coating (1) facing the steel substrate is separated from the steel substrate (3) by the metallic intermediate layer (2), preferably at least 95%, particularly preferably the entire area facing the steel substrate (3)
and/or
- wherein the proportion of titanium in the application of (i) titanium or (ii) titanium and one or more further metals to the steel substrate (3) is selected so that the proportion of titanium in the resulting metallic intermediate layer (2) covering the steel substrate (3) is greater than or equal to 90% by weight based on the total mass of the intermediate layer (2)
and/or
- wherein the resulting metallic intermediate layer (2) whose main constituent is titanium has a thickness of not more than 500 nm, preferably a thickness of not more than 400 nm, particularly preferably a thickness of not more than 300 nm
and/or
- wherein the resulting metallic intermediate layer (2) whose main constituent is titanium has a thickness of at least 100 nm, preferably at least 150 nm.

8. Process according to either of Claims 6 and 7,
wherein
- the application of (i) titanium or (ii) titanium and one or more further metals to the steel substrate so as to result in a metallic intermediate layer (2) which covers the steel substrate and whose main constituent is titantium
and/or
- the application of one or more further metals to the metallic intermediate layer so as to result in an anticorrosion coating (1) covering the intermediate layer
is carried out by means of physical vapour deposition,
preferably
- at a partial pressure of oxygen of less than 0.1 mbar, preferably less than 0.01 mbar, particularly preferably less than 0.001 mbar
and/or
- in a gas phase in which the proportion by volume of oxygen is less than 20% by volume, preferably less than 10% by volume, particularly preferably less than 1% by volume.

## Revendications

1. Composant comprenant
- un substrat en acier (3), dont la structure peut être transformée en une structure martensitique,
- une couche intermédiaire (2) métallique recouvrant le substrat en acier, dont le constituant principal est du titane,
et
- un revêtement de protection anti-corrosion (1) recouvrant la couche intermédiaire (2),
dans lequel le revêtement de protection anti-corrosion (1) comprend une couche ou plus et une ou au moins la couche, reposant sur la couche intermédiaire (2) métallique, du revêtement de protection anti-corrosion (1) est métallique et se distingue sur le plan de la matière de la couche intermédiaire (2),
et
dans lequel la part de titane dans la couche intermédiaire (2) métallique recouvrant le substrat en acier (3) est supérieure ou égale à 90 % en poids par rapport à la masse totale de la couche intermédiaire (2),
et
dans lequel la couche intermédiaire (2) métallique, dont le constituant principal est du titane, possède une épaisseur d'au moins 100 nm.

2. Composant selon la revendication 1, dans lequel
le constituant principal des atomes de métal du revêtement de protection anti-corrosion (1) ou le constituant principal des atomes de métal de la couche métallique, reposant sur la couche intermédiaire (2) métallique, du revêtement de protection anti-corrosion (1) est choisi parmi le groupe constitué de zinc et de manganèse,
et/ou
du zinc métallique et/ou du manganèse métallique sont contenus dans une ou au moins la couche métallique, reposant sur la couche intermédiaire (2) métallique, du revêtement de protection anti-corrosion (1).

3. Composant selon l'une quelconque des revendications précédentes, dans lequel au moins 90 % de la surface, tournée vers le substrat en acier (3), du revêtement de protection anti-corrosion (1) est séparé par la couche intermédiaire (2) métallique du substrat en acier (3), de préférence au moins 95 %, de manière préférée la totalité de la surface tournée vers le substrat en acier (3).

4. Composant selon l'une quelconque des revendications précédentes,
(ii) dans lequel le matériau de la couche intermédiaire (2) métallique recouvrant le substrat en acier, dont le constituant principal est du titane,
- possède un point de fusion qui est supérieur à 1000 °C, de préférence supérieur à 1200 °C, de manière préférée supérieur à 1400 °C, de manière particulièrement préférée supérieur à 1600 °C et/ou
- possède un point d'ébullition qui est inférieur à 4700 °C, de préférence est inférieur à 3500 °C et/ou
(iii) dans lequel
- la couche intermédiaire (2) métallique dont le constituant principal est du titane, possède une épaisseur de 500 nm au maximum, de manière préférée une épaisseur de 400 nm au maximum, de manière particulièrement préférée une épaisseur de 300 nm au maximum
et/ou
- la couche intermédiaire (2) métallique dont le constituant principal est du titane possède une épaisseur d'au moins 150 nm.

5. Composant selon l'une quelconque des revendications précédentes, dans lequel
(i) du zinc métallique est contenu dans une ou au moins la couche métallique, reposant sur la couche intermédiaire (2) métallique, du revêtement de protection anti-corrosion (1), et
- la part en zinc métallique dans le revêtement de protection anti-corrosion (1) recouvrant la couche intermédiaire est supérieure ou égale à 55 % en poids, de préférence est supérieure ou égale à 96 % en poids, par rapport à la masse totale du revêtement de protection anti-corrosion,
et/ou
- le point de fusion du revêtement de protection anti-corrosion ou le point de fusion d'une ou au moins de la couche métallique, reposant sur la couche intermédiaire (2) métallique, du revêtement de protection anti-corrosion (1) est supérieur ou égal à 419 °C, de préférence se situe soit dans la plage de 419 °C à 580 °C soit dans la plage au-dessus de 600 °C
ou
(ii) le point de fusion du revêtement de protection anti-corrosion ou le point de fusion d'une ou au moins de la couche métallique, reposant sur la couche intermédiaire (2) métallique, du revêtement de protection anti-corrosion (1) est supérieur ou égal à 880 °C.

6. Procédé de fabrication d'un composant selon l'une quelconque des revendications 1 à 5, avec des étapes suivantes :
- de fabrication ou de fourniture d'un substrat en acier (3), dans lequel la structure du substrat en acier peut être transformée en une structure martensitique,
- d'application de (i) titane ou (ii) de titane et d'un ou de plusieurs autres métaux sur le substrat en acier de sorte qu'il en résulte une couche intermédiaire (2) métallique recouvrant le substrat en acier, dont le constituant principal est du titane,
- d'application d'un ou de plusieurs métaux sur la couche intermédiaire métallique de sorte qu'un revêtement de protection anti-corrosion (1) recouvrant la couche intermédiaire en résulte.

7. Procédé selon la revendication 6,
- dans lequel l'application de (i) titane ou (ii) de titane et d'un ou de plusieurs autres métaux sur le substrat en acier (3) ainsi que l'application d'un ou de plusieurs autres métaux sur la couche intermédiaire (2) métallique sont effectuées de telle sorte qu'au moins 90 % de la surface, tournée vers le substrat en acier, du revêtement de protection anti-corrosion (1) est séparée du substrat en acier (3) par la couche intermédiaire (2) métallique, de manière préférée au moins 95 %, de manière particulièrement préférée la totalité de la surface tournée vers le substrat en acier (3)
et/ou
- dans lequel, lors de l'application de (i) titane ou (ii) de titane et d'un ou de plusieurs autres métaux sur le substrat en acier (3), la part de titane est choisie de telle sorte que la part de titane dans la couche intermédiaire (2) métallique en résultant recouvrant le substrat en acier (3) est supérieure ou égale à 90 % en poids, par rapport à la masse totale de la couche intermédiaire (2)
et/ou
- dans lequel la couche intermédiaire (2) métallique en résultant dont le constituant principal est du titane, possède une épaisseur de 500 nm au maximum, de manière préférée une épaisseur de 400 nm au maximum, de manière particulièrement préférée une épaisseur de 300 nm au maximum
et/ou
- dans lequel la couche intermédiaire (2) métallique en résultant dont le constituant principal est du titane, possède une épaisseur d'au moins 100 nm, de préférence d'au moins 150 nm.

8. Procédé selon l'une quelconque des revendications 6 à 7,
dans lequel
- l'application de (i) titane ou (ii) de titane et d'un ou de plusieurs autres métaux sur le substrat en acier si bien qu'une couche intermédiaire (2) métallique recouvrant le substrat en acier en résulte, dont le constituant principal est du titane
et/ou
- l'application d'un ou de plusieurs autres métaux sur la couche intermédiaire métallique si bien qu'un revêtement de protection anti-corrosion (1) recouvrant la couche intermédiaire en résulte,
sont effectuées au moyen d'une séparation physique en phase gazeuse,
de préférence
- à une pression partielle d'oxygène inférieure à 0,1 mbar, de manière préférée inférieure à 0,01 mbar, de manière particulièrement préférée inférieure à 0,001 mbar et/ou
- dans une phase gazeuse, dans laquelle la part volumique de l'oxygène est inférieure à 20 % en vol., de préférence inférieure à 10 % en vol., de manière particulièrement préférée est inférieure à 1 % en vol.
